(19) Europäisches Patentamt
European Patent Office
Office européen des brevets

(11) **EP 2 665 999 B1**

(12) **FASCICULE DE BREVET EUROPEEN**

(45) Date de publication et mention de la délivrance du brevet:
**09.12.2015 Bulletin 2015/50**

(21) Numéro de dépôt: **12700813.4**

(22) Date de dépôt: **18.01.2012**

(51) Int Cl.:
**G01K 11/26** (2006.01)    **H03H 9/00** (2006.01)

(86) Numéro de dépôt international:
**PCT/EP2012/050703**

(87) Numéro de publication internationale:
**WO 2012/098156 (26.07.2012 Gazette 2012/30)**

(54) **CAPTEUR DE TEMPÉRATURE COMPORTANT UN RÉSONATEUR À ONDES DE VOLUMES À MODES HARMONIQUES ÉLEVÉS**

TEMPERATURSENSOR MIT EINEM AKUSTISCHEN VOLUMENWELLENRESONATOR MIT HOHEN OBERTÖNEN

TEMPERATURE SENSOR COMPRISING A HIGH-OVERTONE BULK ACOUSTIC RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.01.2011 FR 1150476**

(43) Date de publication de la demande:
**27.11.2013 Bulletin 2013/48**

(73) Titulaires:
• **Centre National de la Recherche Scientifique (CNRS)**
**75016 Paris (FR)**
• **Université de Franche-Comté**
**25000 Besançon (FR)**

(72) Inventeur: **BALLANDRAS, Sylvain, Jean**
**F-25000 Besançon (FR)**

(74) Mandataire: **Domenego, Bertrand**
**Cabinet Lavoix**
**2, place d'Estienne d'Orves**
**75441 Paris Cedex 09 (FR)**

(56) Documents cités:
**EP-A1- 1 748 556    FR-A1- 2 932 333**
**FR-A1- 2 932 334**

• **MANSFELD G D ET AL: "BAW microwave temperature sensor", PROCEEDINGS OF IEEE SENSORS 2004 : [IEEE SENSORS 2004 CONFERENCE] ; OCTOBER 24 - 27, VIENNA UNIVERSITY OF TECHNOLOGY, VIENNA, AUSTRIA, IEEE SERVICE CENTER, PISCATAWAY, NJ, 24 octobre 2004 (2004-10-24), pages 876-878, XP010793545, ISBN: 978-0-7803-8692-1 cité dans la demande**

EP 2 665 999 B1

**Description**

La présente invention concerne un capteur de température, comportant un résonateur de type à ondes de volumes à modes harmoniques élevés (dénommé HBAR, acronyme anglais pour « High overtone Bulk Acoustic Resonator »).

Les résonateurs de type à ondes de volumes à modes harmoniques élevés HBAR sont connus et sont décrits par exemple dans les demandes de brevet français publiées sous les numéros de publication FR 2 932 333 A et FR 2 932 334 A.

De manière générale, un résonateur de type à ondes de volume à modes harmoniques élevés HBAR comprend :

-   un transducteur piézoélectrique ayant un fort coefficient de couplage électro-acoustique permettant d'exciter efficacement les modes d'ordre élevés,
-   un substrat acoustique ayant un produit coefficient de qualité acoustique - fréquence d'excitation élevé,
-   une contre-électrode formée par une couche de métal collant une première face du transducteur et une face du substrat acoustique,
-   une électrode disposée sur une deuxième face du transducteur opposée à la première face du transducteur et le substrat.

Le document de G.D. Mansfeld et al., intitulé « BAW Microwave temperature Sensor », publié dans Sensors Proceeding of IEEE, October 2004, et la demande de brevet européen publiée sous la référence EP 1 748 556 A1 décrivent l'utilisation d'un résonateur de type HBAR comme un capteur de température à dimensions réduites. Dans cette utilisation le déplacement de la fréquence du résonateur en fonction de la température est exploité.

Le document de G.D Mansfeld et al. décrit plus particulièrement un mode de réalisation d'un capteur de température dans lequel le résonateur est configuré en transpondeur. Lorsque le capteur est interrogé à distance par l'envoi d'une onde électromagnétique sous la forme d'une sinusoïde pure, la phase de l'onde réfléchie est mesurée par rapport au signal de référence constitué par le signal d'interrogation, et les variations de la phase mesurée sont représentatives de la température régnant au sein du capteur.

L'inconvénient d'un tel capteur de température est sa sensibilité à un couplage externe au capteur non maîtrisé. Cette sensibilité crée une contribution parasite ou de biais inconnue à la variation de globale de fréquence de résonance du résonateur que l'on ne sait pas estimer et qui vient entacher la mesure d'une erreur.

Le problème technique est de proposer un capteur de température de type à ondes de volume à modes harmoniques élevés HBAR qui tout en gardant des dimensions réduites fournit des mesures de températures très précises à haute résolution dépourvues de l'erreur de biais décrite ci-dessus.

A cet effet l'invention a pour objet un capteur de température comprenant un résonateur de type à ondes de volumes à modes harmoniques élevées HBAR destiné à travailler à une fréquence de travail prédéterminée et dans une plage de température centrée autour d'une température de référence $T_0$, le résonateur comportant :

-   un transducteur piézoélectrique constitué par une couche d'une première épaisseur d'un premier matériau, coupé selon un premier angle de coupe de transducteur $\varphi_1$ défini par la nomenclature (YXw)/φ du standard IEEE Std-176 (révision 1949) égal sensiblement à zéro, et coupé selon un deuxième angle de coupe $\theta_1$ de transducteur défini par la nomenclature (YXl)/θ du standard IEEE Std -176 (révision 1949), tels que le transducteur présente, soit une première direction de polarisation $\vec{P}_{Along}$ d'un premier mode de vibration longitudinal du transducteur, et une deuxiè-me direction de polarisation $\overline{P}_{Acis\_dual}$ d'un deuxième mode de vibration de cisaillement du transducteur, soit une direction unique de polarisation $\overline{P}_{Acis\_seul}$ correspondant à un mode de vibration de cisaillement du transducteur, et tel que le couplage électroacoustique d'une vibration de cisaillement et/ou d'une vibration longitudinal pour le matériau du transducteur est supérieur ou égal à 5%,
-   un substrat acoustique constitué par une couche d'une deuxième épaisseur d'un deuxième matériau ayant un produit coefficient de qualité acoustique - fréquence d'excitation au moins égal à $5.10^{12}$, coupé selon un premier angle de coupe de substrat $\theta_2$ défini par la nomenclature (YXl)/θ du standard IEEE Std-176 (révision 1949), coupé selon un deuxième angle de coupe de substrat $\psi_2$ défini par la nomenclature (YXt)/ψ du standard IEEE Std-176 (révision 1949), présentant aux moins deux directions de polarisation parmi une première direction de polarisation $\vec{P}_{B1}$, une deuxième direction de polarisation $\vec{P}_{B2}$, une troisième direction de polarisation $\vec{P}_{long}$, correspondant res-pectivement à un mode de vibration, de cisaillement du substrat à vitesse de phase lente, à un mode de vibration, de cisaillement du substrat à vitesse de phase rapide, et à un mode de vibration longitudinal du substrat,
-   une contre électrode formée par une couche de métal collant une première face du transducteur et une face du substrat acoustique, et

- une électrode supérieure disposée sur une deuxième face du transducteur opposée à la première face du transducteur et au substrat, caractérisé en ce que

le rapport de la première épaisseur sur la deuxième épaisseur est inférieur ou égal à 0,05;

les angles de coupe $\varphi_1$, $\theta_1$, $\psi_2$, $\theta_2$, et la disposition relative du transducteur et du substrat sont configurés de sorte qu'il existe simultanément au moins deux modes de vibration du substrat couplés fortement à un même degré à au moins un mode de vibration du transducteur, et que

les au moins deux modes de vibration du substrat fortement couplés comprennent un premier mode de vibration ayant un premier coefficient de température de la fréquence de substrat du premier ordre à la température de référence $T_0$ et un deuxième mode de vibration du substrat ayant un deuxième coefficient de température de la fréquence de substrat du premier ordre à la même température de référence, et

le transducteur, pour le premier mode de vibration du substrat, possède un premier coefficient de température de la fréquence de transducteur du premier ordre à la température de référence, et possède pour le deuxième mode de vibration du substrat, un deuxième coefficient de température de la fréquence de transducteur du premier ordre à la température de référence, et

la valeur absolue de la différence d'un premier et d'un deuxième coefficients de température de la fréquence du résonateur du premier ordre est supérieure ou égale à 1 ppm/°K,

le premier coefficient de température de la fréquence du résonateur du premier ordre étant sensiblement égal à la somme du premier coefficient de température de la fréquence du substrat du premier ordre et du premier coefficient de température de la fréquence de transducteur du premier ordre pondéré par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat du premier ordre et du deuxième coefficient de température de la fréquence de transducteur du premier ordre pondéré par les épaisseurs relatives de chaque matériau par rapport à l'épaisseur totale du résonateur.

Suivant des modes particuliers de réalisation, le capteur de température comporte l'une ou plusieurs des caractéristiques suivantes, prises seules ou en combinaison.

- le transducteur piézoélectrique est coupé selon une coupe à simple rotation $(X_1Y_1l)/\theta_1$ tel que le transducteur présente une première direction de polarisation $\vec{P}_{Along}$ d'un premier mode de vibration longitudinal du transducteur et une deuxième direction de polarisation $\vec{P}_{Acis\_dual}$ d'un deuxième mode de vibration de cisaillement du transducteur, et tel que le couplage électroacoustique d'une onde à mode de cisaillement et d'une onde à mode longitudinal pour ce matériau, est supérieur à 5%, et

les angles de coupe $\theta_1$, $\psi_2$, $\theta_2$, et la disposition relative du transducteur et du substrat acoustique sont configurés de sorte qu'il existe simultanément trois modes de vibration du substrat couplés fortement à un même degré à un des deux modes de vibration du transducteur, et que

les trois modes de vibration du substrat fortement couplés comprennent un premier mode de vibration du substrat à cisaillement lent, polarisé suivant $\vec{P}_{B1}$ et ayant un premier coefficient de température de la fréquence de substrat du premier ordre à la température de référence, un deuxième mode de vibration du substrat à cisaillement rapide, polarisé suivant $\vec{P}_{B2}$ et ayant un deuxième coefficient de température de la fréquence de substrat du premier ordre à la température de référence, et un troisième mode de vibration longitudinal, polarisé suivant $\vec{P}_{long}$ et ayant un premier coefficient de température de la fréquence de substrat du premier ordre à la température de référence,

le transducteur pour les premier, deuxième, troisième modes de vibration du substrat, possède respectivement un premier, un deuxième, un troisième coefficients de température de la fréquence de transducteur du premier ordre à la température de référence,

la valeur absolue de la différence de deux quelconques coefficients de température de la fréquence du résonateur du premier ordre d'un ensemble formé par un premier, un deuxième, et un troisième coefficients de température de la fréquence du résonateur du premier ordre, est supérieure ou égale à 1 ppm/°K,

le premier coefficient de température de la fréquence du résonateur du premier ordre est sensiblement égal à la somme du premier coefficient de température de la fréquence du substrat du premier ordre et du premier coefficient de température de la fréquence de transducteur du premier ordre pondéré par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat du premier ordre et du deuxième coefficient de température de la fréquence de transducteur du premier ordre pondéré par les épaisseurs relatives de chaque matériau par rapport à l'épaisseur totale du résonateur, et

le troisième coefficient de température de la fréquence du résonateur étant sensiblement égal à la somme du troisième coefficient de température de la fréquence du substrat du premier ordre et du troisième coefficient de température de la fréquence de transducteur du premier ordre pondéré par les épaisseurs relatives de chaque matériau par rapport à l'épaisseur totale du résonateur ;

- le transducteur piézoélectrique est coupé selon une coupe à simple rotation $(X_1Y_1l)/\theta_1$ telle que le transducteur présente une première direction de polarisation $\vec{P}_{Along}$ d'un premier mode de vibration longitudinal du transducteur et une deuxième direction de polarisation $\vec{P}_{Acis\_dual}$ d'un deuxième mode de vibration de cisaillement du transducteur, et telle que le couplage électroacoustique d'une onde à mode de cisaillement et d'une onde à mode longitudinal pour ce matériau est supérieur à 5%, et

les angles de coupe $\varphi_1$, $\theta_1$, $\psi_2$, $\theta_2$, et la disposition relative du transducteur et du substrat sont configurés de sorte qu'il existe simultanément seulement deux modes de vibration du substrat couplés fortement à un même degré à un des deux modes de vibration du transducteur, et que

les deux modes de vibration du substrat fortement couplés comprennent un premier mode de vibration du substrat à cisaillement ayant un premier coefficient de température de la fréquence de substrat du premier ordre à la température de référence, un deuxième mode de vibration longitudinal ayant un deuxième coefficient de température de la fréquence de substrat du premier ordre à la température de référence

le transducteur pour les premier, deuxième modes de vibration possède respectivement un premier, un deuxième coefficients de température de la fréquence de transducteur du premier ordre à la température de référence,

la valeur absolue de la différence d'un premier et d'un deuxième coefficients de température de la fréquence du résonateur du premier ordre est supérieure ou égale à 1 ppm/°K,

le premier coefficient de température de la fréquence du résonateur du premier ordre étant sensiblement égal à la somme du premier coefficient de température de la fréquence du substrat du premier ordre et du premier coefficient de température de la fréquence de transducteur du premier ordre pondérée par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat du premier ordre et du deuxième coefficient de température de la fréquence de transducteur du premier ordre pondérée par les épaisseurs relatives de chaque matériau par rapport à l'épaisseur totale du résonateur ;

- le matériau du transducteur piézoélectrique est du niobate de litihium ou du tantalate de litihum et le transducteur est coupé selon une coupe à simple rotation $(Y_1X_1l)/\theta_1$ dans laquelle l'angle de coupe $\theta_1$ est un angle compris entre 0° et 25° ;
- le transducteur piézoélectrique est coupé selon une coupe à simple rotation $(X_1Y_1l)/\theta_1$ telle que le transducteur présente une direction unique de polarisation $\vec{P}_{Acis\_seul}$ correspondant à un mode de vibration de cisaillement du transducteur, et telle que le couplage électroacoustique d'une vibration de cisaillement et/ou d'une vibration longitudinale pour le matériau du transducteur est supérieur ou égal à 5%,

les angles de coupe $\theta_1$, $\psi_2$, $\theta_2$, et la disposition relative du transducteur et du substrat sont configurés de sorte qu'il existe simultanément deux modes de vibration à cisaillement à vitesses de phase différentes, couplés fortement à un même degré au mode de vibration transversal du transducteur, et que

les deux modes de vibration du substrat fortement couplés comprennent un premier mode de vibration du substrat à cisaillement lent ayant un premier coefficient de température de la fréquence de substrat du premier ordre à la température de référence, un deuxième mode de vibration à cisaillement rapide du substrat ayant un deuxième coefficient de température de la fréquence de substrat du premier ordre à la température de référence

l'angle formé entre la direction unique de polarisation de cisaillement du transducteur et la direction de polarisation de cisaillement à vitesse de phase lente du substrat, et l'angle formé entre la direction unique de polarisation de cisaillement du transducteur et la direction de polarisation de cisaillement à vitesse de phase rapide du substrat sont sensiblement égaux et de mesure égale à 45 degrés ;

le transducteur pour les premier, deuxième modes de vibration possède respectivement un premier, un deuxième coefficients de température de la fréquence de transducteur du premier ordre à la température de référence,

la valeur absolue de la différence d'un premier et d'un deuxième coefficients de température de la fréquence du résonateur du premier ordre est supérieure ou égale à 1 ppm/°K,

le premier coefficient de température de la fréquence du résonateur du premier ordre étant sensiblement égal à la somme du premier coefficient de température de la fréquence du substrat du premier ordre et du premier coefficient de température de la fréquence de transducteur du premier ordre pondérée par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat du premier ordre et du deuxième coefficient de température de la fréquence du transducteur du premier ordre pondérée par les épaisseurs relatives de chaque matériau par rapport à l'épaisseur totale du résonateur ;

- le matériau du transducteur piézoélectrique est du niobate de litihium ou du tantalate de lithium et le transducteur est coupé selon une coupe à simple rotation $(Y_1X_1l)/\theta_1$ dans laquelle l'angle de coupe $\theta_1$ est un angle compris entre 155 et 176° ;
- un premier coefficient de température de la fréquence du substrat acoustique est sensiblement nul ou de signe opposé au deuxième coefficient de température de la fréquence du substrat ;
- la coupe du substrat est telle que le coefficient de température de la fréquence du premier ordre correspondant à l'au moins un mode de cisaillement du substrat est sensiblement nul avec inversion de son signe de part et d'autre d'un angle définissant la coupe du substrat ;
- le coefficient de température de la fréquence du premier ordre du substrat correspondant à l'au moins un des modes de cisaillement du substrat est un extrémum local en valeur absolue inférieur à 20 ppm.K$^{-1}$ et la variation du coefficient de température au voisinage de cet extrémum est une variation douce inférieure en valeur absolue à 2 ppm.K$^{-1}$/degré;
- le matériau du transducteur est choisi parmi le nitrure d'aluminium (AlN), l'oxyde de zinc (ZnO), le niobate de lithium (LiNbO$_3$), le tantalate de lithium (LiTaO$_3$), le niobate de potassium, le PZT, le PbTiO3 et les céramiques piézoélectriques à fort couplage électromécanique, et

le matériau du substrat acoustique est choisi parmi le quartz, le niobate de potassium, la tantalate de lithium, l'orthophosphate de gallium, le tétraborate de lithium, la langasite, la langatate et la langanite ;

- la contre-électrode est un métal thermo-compressible, par exemple l'or, le cuivre ou l'indium et l'électrode supérieure est réalisée par exemple en aluminium ;
- le transducteur piézoélectrique est réalisé en niobate de lithium ; et

le matériau du substrat acoustique est du quartz et le substrat acoustique est coupé selon une coupe à simple rotation dans laquelle l'angle de coupe $\varphi_2$ est nul, et $\theta_2$ est un angle compris entre -60 et 45 degrés ;

- l'angle de couple $\theta_1$ de la coupe $(Y_1X_1l)/\theta_1$ du niobate de litihium est choisi dans un intervalle compris entre 160 et 170°, de préférence 163°, et l'angle de coupe $\theta_2$ de la coupe $(Y_2X_2l)/\theta_2$ du substrat acoustique est choisi entre -48 et 35 degrés ;
- l'angle de coupe $\theta_2$ de la coupe $(Y_2X_2l)/\theta_2$ du substrat acoustique est choisi entre -10 et 10° ;
- le capteur comprend une unité de détermination de la différence entre une première fréquence de résonance et une deuxième fréquence de résonance du résonateur HBAR à une température T régnant au sein du résonateur, mesurées entre les deux électrodes de la même paire du résonateur, et

une unité de détermination de la température T du résonateur à partir de la différence de fréquences déterminée et d'une fonction biunivoque de correspondance entre la température et la différence de fréquences.

L'invention sera mieux comprise à la lecture de la description de plusieurs formes de réalisation qui vont suivre, données uniquement à titre d'exemples et faites en se référant aux dessins dans lesquels :

- La Figure 1 est une vue schématique d'un capteur de température selon l'invention ;
- la Figure 2 est une vue en perspective d'un premier mode de réalisation d'un résonateur HBAR du capteur de température de la Figure 1 ;
- la Figure 3 est une vue d'une coupe transversale du résonateur de la Figure 2 selon la ligne III-III ;
- la Figure 4 est une vue d'une coupe à simple rotation notée $(Y_iX_il_i)/\theta_i$ conformément au standard IEEE Std-176 sur la piézoélectricité d'un cristal désigné par l'indice i ;
- la Figure 5 est une vue d'une coupe à double rotation notée $(Y_iX_il_it_i)/\theta_i/\psi_i$ d'un cristal désigné par l'indice i ;
- la Figure 6 est une vue d'une coupe à double rotation $(Y_iX_iw_il_i)/\varphi_i/\theta_i$ d'un cristal désigné par l'indice i ;
- la Figure 7 est une vue de l'évolution de la vitesse de phase des ondes de volume d'un cristal de niobate de lithium en fonction d'un angle de coupe $\theta_1$ pour la famille d'orientations cristallines notée $Y_1X_1l/\theta_1$ ;
- la Figure 8 est une vue de l'évolution des coefficients de couplage des mêmes ondes que celles de la Figure 7 pour le niobate de lithium en fonction de l'angle de coupe $\theta_1$ ;
- la Figure 9 est une vue de l'évolution du coefficient de température d'un résonateur de la Figure 1 pour un empilement d'une plaque niobate de lithium de coupe $(Y_1X_1l)/15°$ et d'une plaque de quartz de coupe $(Y_2X_2lt)/35°/45°$ pour un rapport d'épaisseur de 1 μm de niobate de lithium sur 50 μm de quartz ;

- la Figure 10 est une vue graphique par courbes de niveau de l'évolution du coefficient de température de fréquence du premier ordre CTFB1 du mode de polarisation longitudinale dans le quartz en fonction du premier angle de coupe $\varphi_2$ et du deuxième angle de coupe θ2 pour la famille d'orientations cristallines $Y_2X_2lt$ ;
- la Figure 11 est une vue graphique par courbes de niveau de l'évolution du coefficient de température de fréquence du premier ordre CTFB1 du mode de polarisation d'une onde de cisaillement à vitesse de phase rapide dans le quartz en fonction du premier angle de coupe $\varphi_2$ et du deuxième angle de coupe θ2 pour la famille d'orientations cristallines $Y_2X_2lt$ ;
- la Figure 12 est une vue graphique par courbes de niveau de l'évolution du coefficient de température de fréquence du premier ordre CTFB1 du mode de polarisation d'une onde de cisaillement à vitesse de phase lente dans le quartz en fonction du premier angle de coupe $\varphi_2$ et du deuxième angle de coupe $\theta_2$ pour la famille d'orientations cristallines $Y_2X_2lt$ ;
- la Figure 13 est une vue de l'évolution des coefficients de température de fréquence du premier du mode de vibration longitudinal, du mode de cisaillement à vitesse de phase lente, du mode de cisaillement à vitesse de phase rapide à l'intérieur d'un cristal de niobate de lithium de coupe à simple rotation $Y_1X_1l$ en fonction de l'angle de coupe $\theta_1$ ;
- la Figure 14 est une vue en perspective d'un deuxième mode de réalisation d'un capteur de température de la Figure 1 dans lequel l'angle de coupe du niobate est choisi pour un couplage électroacoustique des modes de cisaillement seulement ;
- la Figure 15 est une vue de l'évolution des coefficients de température de la fréquence des ondes de volume de cisaillement lente dans le quartz coupé selon une coupe à simple rotation $(Y_2X_2l)/\theta_2$ avec $-90°<\theta_2<+90°$;
- la Figure 16 est une vue de l'évolution en parallèle d'une famille paramétrée par le premier angle de coupe $\theta_2$ de paires de coefficients de température de fréquence associés à deux modes de vibration de polarisation différente en fonction des modes harmoniques de l'empilement niobate de lithium $(Y_1X_1l)/165°$ sur quartz $(Y_2X_2lt)/\theta2/45°$ avec θ2 variant de 32 à 40° ;
- la Figure 17 est une vue de l'évolution de deux fréquences de résonance d'un résonateur formé par un empilement de niobate de lithium et de quartz, configuré pour fonctionner dans la bande ISM (Industrie-Scientifique-Médical) centrée en 434 MHz, en fonction de la température.

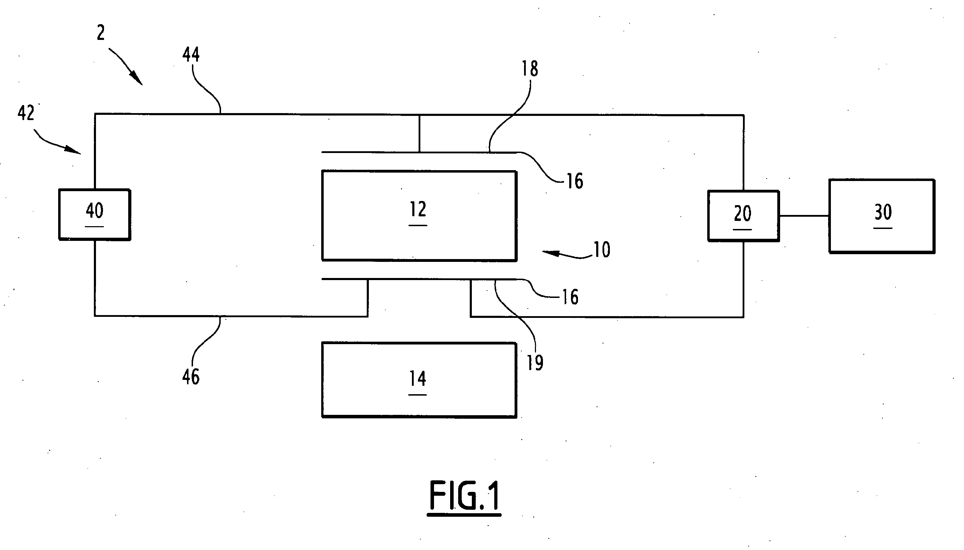

Suivant la Figure 1, un capteur de température 2 selon l'invention comprend :

- un résonateur 10 de type à ondes de volume à harmoniques élevées HBAR comportant un empilement d'un transducteur électro-acoustique 12 et d'un substrat acoustique 14, et une paire 16 d'électrodes 18 et 19 enserrant le transducteur 12,
- une unité 20 de détermination d'une différence de fréquences ΔF, branchée en son entrée et en parallèle sur la paire 16 d'électrodes 18, 19 du résonateur HBAR 10, et
- une unité 30 de détermination de la température T du résonateur à partir de la différence ΔF de fréquences déterminée par l'unité 20 et d'une fonction biunivoque g de correspondance entre la température T régnant à l'intérieur du résonateur et la différence de fréquences déterminée ΔF, suivant une relation : ΔF = g(T).

Le capteur de température 2 comprend également une source d'excitation 40 du capteur 2 couplée au résonateur 10 par la paire 16 des deux électrodes 18, 19 au travers d'une liaison 42, réalisée ici sur la Figure 1 par deux éléments métalliques 44, 46.

La liaison 42 peut également être réalisée sous la forme d'une liaison sans fil au travers d'un champ électromagnétique émis par la source d'excitation 40.

Le résonateur 10 est configuré suivant des rapports d'épaisseurs de ses constituants principaux, formés par le transducteur 12 et le substrat acoustique 14, et suivant des orientations relatives entre les réseaux cristallographiques des cristaux constituant le transducteur 12 et le substrat acoustique 14, de sorte à générer, lorsque le résonateur 10 est excité convenablement, au moins deux modes de vibrations polarisés différemment et orthogonalement dont les fréquences de résonances sont différentes.

L'unité de détermination 20 de la différence de fréquences ΔF est apte à déterminer la différence entre une première fréquence de résonance F1 et une deuxième fréquence de résonnance F2 mesurées entre les deux électrodes 18, 19 de la même paire 16 du résonateur HBAR 10.

L'unité de détermination 20 de la différence de fréquences est réalisée par exemple par un mélangeur de fréquences suivi d'un filtre passe-bande ou passe-bas. Elle peut également consister en une détection des maxima de la réponse électrique du résonateur correspondant aux résonances selon un principe comparable à celui d'une mesure par analyse spectrale, l'écart de fréquence étant alors calculé numériquement à partir des valeurs de fréquences ainsi identifiés.

L'unité de détermination de la température 30 est apte à déterminer la température T du résonateur 10 à partir de la différence de fréquences déterminée par l'unité 20 et de la fonction biunivoque g de correspondance entre la température T et la différence de fréquences ΔF.

Plusieurs structures de résonateur HBAR en termes de coupes cristallographiques des plaques du transducteur 10 et du substrat acoustique 12, et/ou de position relative de pivotement des plaques autour d'une même normale, et de rapport d'épaisseurs sont envisageables pour réaliser le capteur de température 2 de la Figure 1.

Afin de déterminer une telle structure, on étudie les sensibilités en température de différents modes de vibration du résonateur, c'est-à-dire du transducteur 10 et du substrat acoustique 12, en particulier les ondes de volume longitudinales, de cisaillement rapide et de cisaillement lent dans le cas d'un substrat acoustique formé par du quartz, pour différentes orientations cristallines.

Il est connu que les propriétés physiques du résonateur 10 évoluent avec la température, ce qui modifie le comportement électro-acoustique du résonateur 10, et provoque une dérive de la fréquence de synchronisme du résonateur. En étudiant ces propriétés physiques en fonction de la température, par exemple selon l'approche connue dite de Campbell et Jones, il est possible de déterminer une loi reliant la fréquence de résonance d'un mode de vibration du résonateur 10 à la température. Cette loi met en oeuvre des coefficients de température de la fréquence, qui dépendent en particulier des angles de coupe et des épaisseurs du transducteur 10 et du substrat 12.

L'approche dite de Campbell et Jones est décrite dans l'article de J.J. Campbell, W.R. Jones, « A method for estimating crystals cuts and propagation direction for excitation of piezoelectric surface waves », IEEE Transactions on Sonics and Ultrasonics, Vol. 15, pp. 209-217, 1968.

En choisissant les angles de coupe et les épaisseurs du transducteur 10 et du substrat 12 de telle sorte que la différence des coefficients de température du premier ordre du résonateur 10 de deux modes de vibration suffisamment couplés par le transducteur 10 présente une valeur supérieure ou égale à 1 ppm/°K, on peut alors établir une relation entre la température et la différence des fréquences de résonance rejetant les sources de bruit et les parasites. Cet effet définit la sensibilité du capteur de température 2, et on réalise ainsi un capteur de température précis et de faibles dimensions.

De préférence, les angles de coupe et les épaisseurs du transducteur 10 et du substrat 12 sont choisis de telle sorte que la différence des coefficients de température du premier ordre du résonateur 10 de deux modes de vibration suffisamment couplés par le transducteur 10 présente une valeur supérieure ou égale à 3 ppm/°K, lorsque cette sensibilité est atteignable sur la plage de température que l'on cherche à mesurer et compatible de la bande de fréquences permise par les normes de radiofréquences.

En effet, en connaissant les fréquences de résonance des premier et second modes de vibration à une température de référence $T_0$, et en connaissant la loi reliant la fréquence de résonance à la température, il est possible de déduire la température ambiante T régnant au sein du résonateur 10 en mesurant et en comparant les fréquences de résonance de ces premier et second modes de vibration à cette température ambiante T.

L'expression de la première fréquence de résonance $F_1(T)$ à la température T d'un premier mode de résonance s'écrit sous la forme la plus générale :

$$F_1(T) = F_{1,0}(T_o)\left[1 + \theta_{\alpha 1}(T - T_0) + \theta_{\alpha 2}(T - T_0)^2 + \theta_{\alpha 3}(T - T_0)^3\right]$$

dans laquelle:

T₀ est la température de référence souvent définie à 25°C, $F_{1,0}(T_o)$ est une constante représentative de la fréquence du premier ordre à la température de référence, $\theta_{\alpha 1}$, $\theta_{\alpha 2}$, $\theta_{\alpha 3}$ sont respectivement les coefficients des premier, deuxième, troisième ordres de température de la fréquence du premier mode de résonance du résonateur 10.

L'expression de la deuxième fréquence de résonance $F_2(T)$ à la température T d'un deuxième mode de résonance couplé par le transducteur à un même degré que le premier mode s'écrit sous la forme la plus générale :

$$F_2(T) = F_{2,0}(T_o)\left[1 + \theta_{\beta 1}(T - T_0) + \theta_{\beta 2}(T - T_0)^2 + \theta_{\beta 3}(T - T_0)^3\right]$$

dans laquelle :

T₀ est une température de référence, $F_{2,0}(T_o)$ est une constante représentative de la fréquence du deuxième mode à la température de référence $\theta_{\beta 1}$, $\theta_{\beta 2}$, $\theta_{\beta 3}$ sont respectivement les coefficients des premier, deuxième, troisième ordres de température de la fréquence du deuxième mode de résonance du résonateur 10

L'expression de la différence de fréquences s'écrit donc sous la forme la plus générale :

$$\Delta F(T) = \Delta F_0(T_0)\left[1 + \Delta\theta_1(T-T_0) + \Delta\theta_2(T-T_0)^2 + \Delta\theta_3(T-T_0)^3\right]$$

dans laquelle les constantes $\Delta F_0(T_0)$, $\Delta\theta_1$, $\Delta\theta_2$, $\Delta\theta_3$ sont calculées à partir des constantes $F_{1,0}(T_0)$, $\theta\alpha_1$, $\theta\alpha_2$, $\theta\alpha_3$, $F_{2,0}(T_0)$, $\theta_{\beta1}$, $\theta_{\beta2}$, $\theta_{\beta3}$.

On notera que les coefficients de température de la fréquence des premier et second modes sont de préférence les plus éloignés possibles, de sorte que même de faibles variations de température influent de manière perceptible sur la variation de la différence entre les fréquences de résonance de ces premier et second modes. Ainsi, on obtient un capteur de température particulièrement précis.

En outre, un résonateur de type à ondes de volumes à modes harmoniques élevés HBAR possède de faibles dimensions, son volume étant généralement inférieur au millimètre cube.

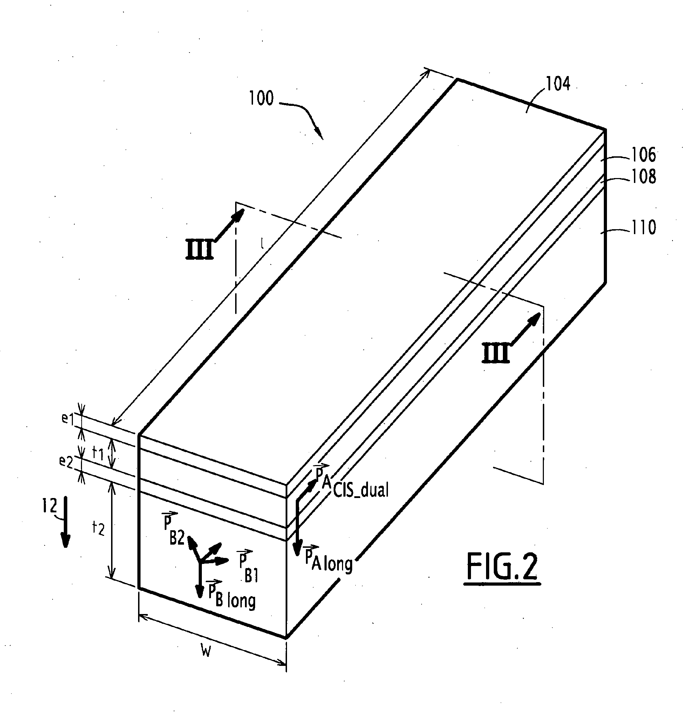

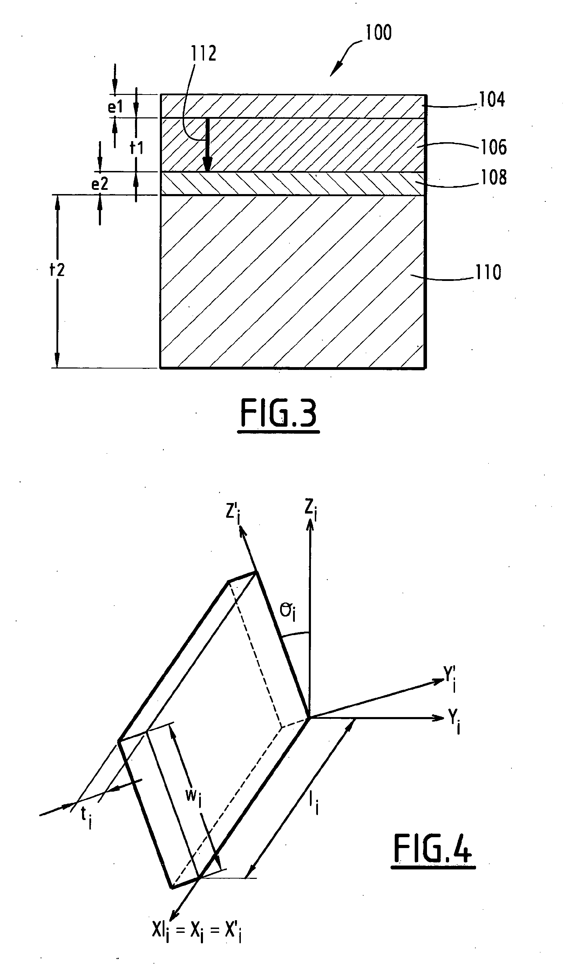

Suivant les Figures 2 et 3, une première forme de réalisation 100 d'un résonateur 10 de type à ondes de volume à harmoniques élevées HBAR du capteur de température 2 de la Figure 1 comprend un empilement de couches successives comportant :

- une électrode supérieure 104, formant l'électrode 18 du résonateur 10 de la figure 1, en aluminium et d'épaisseur $e_1$,
- un transducteur piézoélectrique 106 constitué d'un premier matériau, ici du niobate de lithium (LiNbO$_3$), sous forme monocristalline ayant une première épaisseur $t_1$,
- une contre-électrode 108 en or, enterrée, d'épaisseur $e_2$, formant l'électrode de la figure 1,
- un substrat acoustique 110 constitué d'un deuxième matériau, ici du quartz, sous forme monocristalline ayant une deuxième épaisseur $t_2$.

Toutes les couches 104, 106, 108 et 110 présentent sur la Figure 2 la même longueur L et la même largeur W, la longueur L et la largeur W étant nettement supérieures aux différentes épaisseurs de couche $e_1$, $t_1$ et $e_2$.

Le rapport de la première épaisseur $t_1$ sur la deuxième épaisseur $t_2$ est de préférence inférieur ou égal à 0,05.

Pour simplifier la figure 2, les électrodes 104, 108 sont représentées de surfaces égales à celles du transducteur piézoélectrique 106.

En pratique, les électrodes 104, 108 présentent des surfaces inférieures à celles de la couche piézoélectrique 106, et l'électrode supérieure 104 présente une surface inférieure ou égale à celle de contre-électrode 108 enterrée.

Dans le procédé de fabrication incluant une couche enterrée servant de couche de collage, la contre-électrode 108 présente naturellement une surface supérieure à celle de l'électrode supérieure 104 fabriquée par une technique de lithographie et de dépôt de couche métallique.

Les surfaces des électrodes 104, 108 sont disposées en vis à vis, parallèles entre elles, les zones respectives en regard des surfaces étant maximales, avec des bords le plus parallèle possible. Dans le cas idéal, les surfaces des électrodes 104, 108 sont superposées parfaitement.

Ainsi, l'excitation des ondes est supposée correspondre à une configuration de résonateur dit plan-plan, pour laquelle les ondes sont excitées par les électrodes 104, 108 très minces, déposées sur les surfaces en regard du transducteur piézoélectrique 106. Les ondes de volume acoustiques vont pouvoir s'établir sur un nombre de longueur d'ondes proportionnel à l'ordre de l'harmonique (1 pour 2) au sein de la zone résonante, le sens de propagation des ondes acoustiques étant représenté par la flèche 112.

Le transducteur piézoélectrique 106 est configuré pour présenter deux modes de polarisation des vibrations, un premier mode longitudinal pour lequel le cristal se déforme dans une même direction $\vec{P}_{Along}$ que celle 112 de la propagation de l'onde acoustique, et un deuxième mode de vibration à cisaillement ou transverse dont le vecteur de polarisation $\vec{P}_{Acis\_dual}$ a une direction orthogonale à celle du vecteur de polarisation de la vibration en mode longitudinal.

Pour les coupes à simples rotation de niobate de lithium et de tantalate de lithium le deuxième mode de vibration à cisaillement est un mode de cisaillement rapide.

Le substrat acoustique 110 est configuré pour présenter trois modes de vibrations polarisées différemment, un premier mode de vibration polarisée longitudinalement représenté par un premier vecteur de polarisation $\vec{P}_{Blong}$ de direction parallèle à la direction de propagation 112, un deuxième mode de vibration polarisée transversalement à vitesse de phase lente représenté par un deuxième vecteur de polarisation $\vec{P}_{B1}$ de direction orthogonale à la direction de propagation 112, et un troisième mode de vibration polarisée transversalement à vitesse de phase rapide représenté par un troisième vecteur de polarisation $\vec{P}_{B2}$ de direction orthogonale à la direction de propagation 112 et à la direction du deuxième vecteur de polarisation $\vec{P}_{B1}$.

Les modes de vibration transverses ou de cisaillement définissent des ondes de cisaillement à vitesse de phase lente et des ondes de cisaillement à vitesse de phase rapide qui se propagent à l'intérieur du substrat acoustique 110 selon la direction de propagation 112, les ondes dites rapides ayant une vitesse de phase supérieure aux ondes dites lentes.

La contre-électrode 108 interposée entre le transducteur 106 et le substrat acoustique 110 sert en outre de colle à la structure du résonateur 2.

La couche de niobate de lithium (LiNbO$_3$), constituant le transducteur 106, est une plaque découpée dans un matériau brut monocristallin formant une tranche dénommée « wafer » en anglais. La plaque est ici découpée selon une coupe à simple rotation désignée par (Y$_1$X$_1$lt)/$\theta_1$ par le standard IEEE Std-176 (révision 1949) dans laquelle $\theta_1$ désigne un angle de coupe.

La couche de quartz constituant le substrat acoustique 110 est une plaque découpée dans un matériau brut monocristallin formant une tranche dénommée « wafer » en anglais. La plaque est ici découpée selon une coupe à double rotation désignée par (Y$_2$X$_2$lt)/$\theta_2$/$\psi_2$ par le standard IEEE Std-176 (révision 1949) dans laquelle $\theta_2$ désigne un premier angle de coupe et $\psi_2$ un deuxième angle de coupe.

On rappelle ici et pour la suite la définition des angles de coupe, selon le standard IEEE Std-176 (révision 1949). Les axes notés X$_i$, Y$_i$ et Z$_i$, avec i un indice variant de 1 à 2, désignent les axes cristallographiques d'un cristal, i étant égal à 1 lorsque le cristal est un transducteur du résonateur et i étant égal à 2 lorsque la cristal est un substrat acoustique du résonateur. Une plaque de coupe est notée (Y$_i$X$_i$) lorsque la normale à cette plaque de coupe est l'axe Y$_i$ et que la direction de propagation est l'axe X$_i$. On définit également les directions w$_i$ (suivant la largeur de la plaque de coupe), l$_i$ (suivant sa longueur, donc la direction de propagation), et t$_i$ (perpendiculaire à la plaque de coupe), avec la même convention pour i.

Un angle de coupe est défini en partant de la plaque de coupe (YX) et en appliquant trois rotations successives. La rotation autour de w$_i$ est notée $\varphi_i$, la rotation autour de l$_i$ est notée $\theta_i$, et la rotation autour de t$_i$ est notée $\psi_i$.

Une coupe à simple rotation, désignée par (Y$_i$X$_i$l)/8$_i$ et illustrée sur la Figure 4, est obtenue en partant de la plaque de coupe (Y$_i$X$_i$) et en appliquant la rotation unique autour de l'axe l$_i$ selon l'angle $\theta_i$.

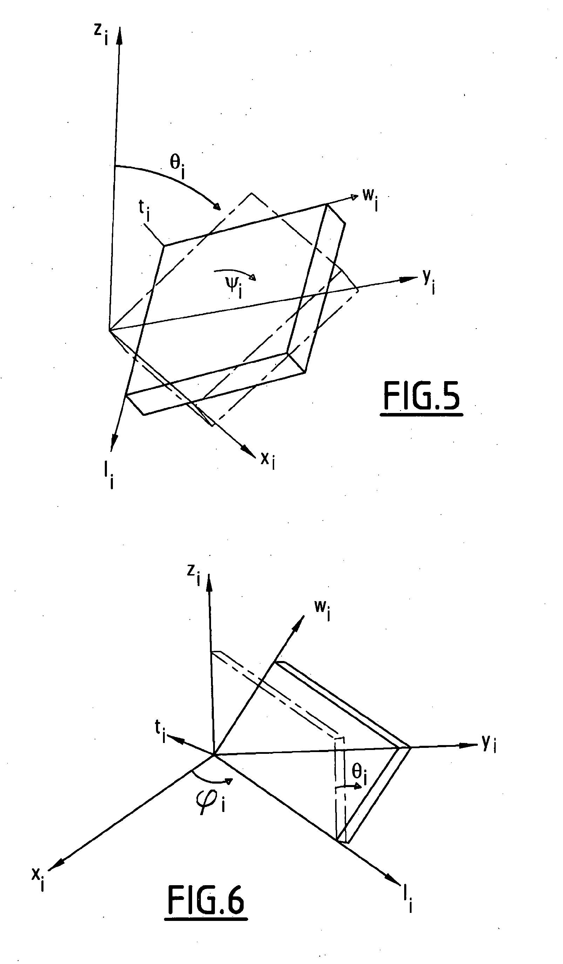

Une coupe à double rotation, désignée par (Y$_i$X$_i$lt)/$\theta_i$/$\psi_i$ et illustrée sur la Figure 5, est obtenue en partant de la plaque de coupe (Y$_i$X$_i$) et en appliquant successivement une première rotation d'angle $\theta_i$ .autour de l$_i$ et une rotation d'angle $\psi_i$ autour de t$_i$.

Une coupe à double rotation, désignée par (Y$_i$X$_i$wt)/$\varphi_i$/$\theta_i$ et illustrée sur la Figure 6, est obtenue en partant de la plaque de coupe (Y$_i$X$_i$) et en appliquant successivement une première rotation d'angle $\varphi_i$ autour de w$_i$ et une rotation d'angle $\theta_i$ autour de l$_i$.

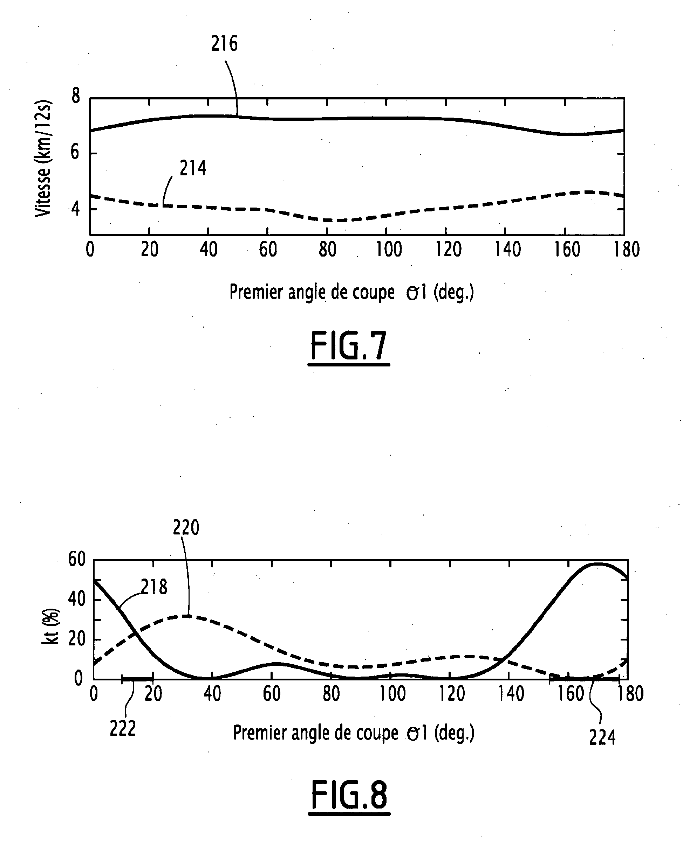

La Figure 7 représente l'évolution de la vitesse de phase des ondes longitudinales et de cisaillement pour des coupes à simple rotation autour de l'axe cristallographique XI$_1$ du transducteur 106 pour le niobate de lithium.

Le courbe 214 représente la vitesse de phase des ondes de cisaillement de propageant dans le transducteur 106 selon l'axe normal aux plans des électrodes 104 et 108 en fonction de l'angle de coupe $\theta_1$.

La courbe 216 représente la vitesse de phase des ondes longitudinales, exprimées en km/s, se propageant dans le transducteur 106 selon l'axe de la longueur l$_1$ en fonction du premier angle de coupe $\theta_1$, exprimé en degrés.

La Figure 8 représente le couplage des ondes longitudinales et de cisaillement pour les coupes à simple rotation autour de l'axe cristallographique XI$_1$ du transducteur 106.

La courbe 218 représente l'évolution du coefficient de couplage K$_T$ exprimée en pourcentage d'énergie électrique convertie en énergie acoustique pour des ondes de cisaillement en fonction du premier angle de coupe $\theta$1 exprimé en degrés.

La courbe 220 représente l'évolution du coefficient de couplage K$_T$ exprimée en pourcentage d'énergie électrique convertie en énergie acoustique pour des ondes longitudinales en fonction du premier angle de coupe $\theta_1$ exprimé en degrés.

Sur la Figure 8 les courbes 218, 220 présentent une première zone angulaire 222 centrée autour de la valeur 15° et comprise entre 10° et 20° dans laquelle l'onde longitudinale et l'onde de cisaillement sont couplées chacune par piézoélectricité et contribuent chacune à un même degré à la réponse électrique du transducteur 10, et l'excitation à la fois de l'onde longitudinale et de l'onde de cisaillement est particulièrement efficace avec un couplage électromécanique compris entre 15% et 25%.

Sur la Figure 8 les courbes 218, 220 présentent une deuxième zone angulaire 223 centrée autour de la valeur 5° et comprise entre 0° et 15° dans laquelle le mode de cisaillement présente un couplage double de celui du mode longitudinal. Le couplage du mode de cisaillement est de l'ordre de 20 à 30% et celui du mode longitudinal de 5 à 15%. Dans ce cas il est obtenu deux fois plus de couplage sur le mode de cisaillement que sur le mode longitudinal, ce qui permet d'exciter au même niveau de couplage électromécanique trois ondes dans le substrat, soit les deux ondes de cisaillement et l'onde longitudinale. Cette configuration est importante pour une application d'interrogation à distance où l'on va chercher à obtenir des contributions bien équilibrées de chaque mode pour des raisons de minimisation de la sensibilité des écarts de fréquences entre modes à l'environnement électromagnétique.

Sur la Figure 8, les courbes 218 et 220 présentent une troisième zone 224, centrée autour de la valeur de 163° et comprise entre 158° et 168°, dans laquelle l'onde longitudinale n'est quasiment pas couplée par piézoélectricité et ne contribue donc pas à la réponse électrique du transducteur 206 et l'excitation de l'onde de cisaillement est particulièrement efficace avec un couplage électromécanique compris entre 50 et 60%.

L'angle de coupe $\theta_1$ de la plaque de niobate de lithium formant le transducteur 106 de la Figure 2, est choisi de préférence dans la première zone 222 compris entre 10° et 20°.

En pratique, une valeur de l'angle de coupe $\theta_1$ telle que les couplages électroacoustiques d'une vibration de cisaillement et d'une vibration longitudinale pour le matériau du transducteur sont égaux ou supérieurs à 5% convient et peut être ainsi choisie entre 0° et 23°. Les mêmes valeurs angulaires sont applicables pour le tantalate de lithium qui est un matériau à utiliser pour le transducteur également avantageux.

Pour une telle valeur choisie de l'angle de coupe $\theta_1$, le transducteur 106 est apte à créer deux modes de vibration : un mode de vibration longitudinale et un mode de vibration transverse ou à onde de cisaillement.

La coupe de la plaque de quartz formant le substrat acoustique 110 de la Figure 2 est une coupe cristallographique du type $(Y_2X_2It)/\theta_2/\psi_2$ dans laquelle l'angle de coupe $\theta_2$ est choisi dans un intervalle centré autour de 35° et d'amplitude égal à 10°, et dans laquelle l'angle de coupe $\psi_2$ est choisi dans un intervalle centré autour de 45° et d'amplitude 10°. De la sorte par projection, l'onde de cisaillement excitée dans le transducteur peut se répartir entre les deux modes de cisaillement du substrat à efficacité identique.

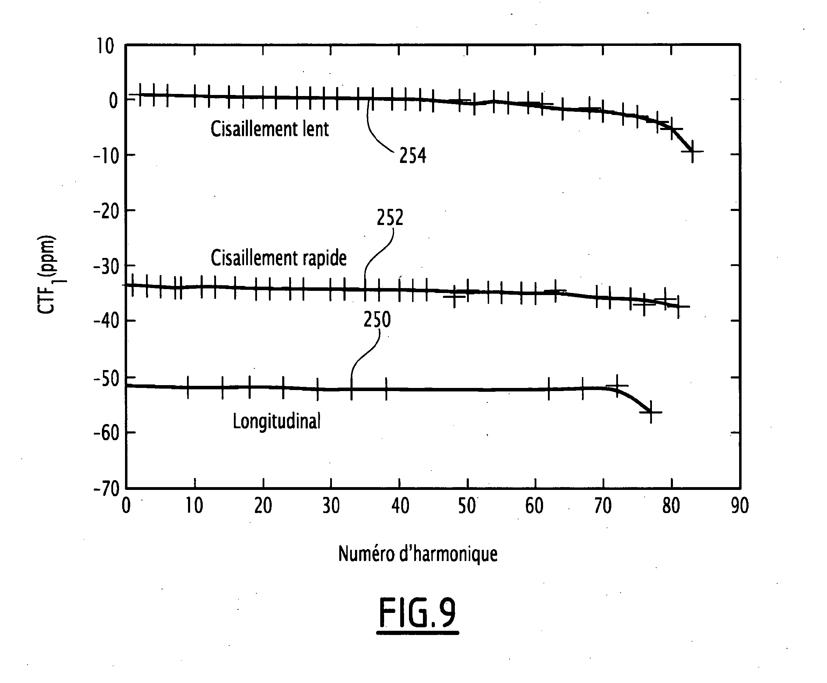

La Figure 9 montre l'évolution des coefficients de température de fréquence du premier ordre CFT1 du mode longitudinal, des modes de cisaillement à vitesses de phase lente et rapide en fonction du rang d'harmonique des vibrations pour la configuration particulière d'un empilement sans pivotement des plaques entre elles d'une plaque de niobate de lithium de coupe (YX$l$)/15° et d'une plaque de quartz (Y2X2lt)35°/45° et d'un rapport d'épaisseur 1 $\mu$m de niobate sur 50 $\mu$m de quartz.

Une courbe 250, respectivement des courbes 252, 254, représentent l'évolution du CTF1 pour le mode de vibration longitudinal, respectivement pour le mode de vibration transversal à cisaillement rapide et pour le mode de vibration transversal à cisaillement lent.

Il est rappelé que la valeur de 15° pour l'angle de coupe la plaque de niobate de lithium a été choisie pour obtenir un couplage comparable de même degré des modes longitudinaux et de cisaillement.

Il est à remarquer que puisque le mode de cisaillement servira à exciter aussi les modes lent et rapide dans le quartz, il est légitime de réduire cet angle $\theta_1$ vers les 10° et de tirer parti d'un couplage du mode de cisaillement plus fort que celui du mode longitudinal, dans un souci d'équilibrage des contributions modales à la réponse électrique du résonateur.

Ainsi trois cas peuvent être distingués : un premier cas où l'on cherche à exciter à égale efficacité deux modes de cisaillement seuls, un deuxième cas où l'on cherche à exciter à égale efficacité un mode de cisaillement et un mode longitudinal, et un troisième cas où l'on cherche à exciter à égale efficacité les trois modes possibles.

Les configurations optimales correspondantes à ces trois cas sont respectivement un empilement d'une plaque de niobate de litihium de coupe $(Y_1X_1l)/163°$ et d'une plaque de quartz $(Y_2X_2It)/35°/45°$, un empilement d'une plaque de niobate de lithium de coupe $(Y_1X_1l)/15°$ et d'une plaque de quartz $(Y_2X_2It)/35°/90°$ et un empilement d'une plaque de niobate de lithium de coupe $(Y_1X_1l)/15°$ et d'une plaque de quartz $(Y_2X_2It)/35°/45°$.

Le choix de la valeur de 35° pour l'angle $\theta_2$ permet avantageusement de disposer d'un mode stable en température pouvant servir de référence en fréquence. Ici, il s'agit du mode de cisaillement à vitesse de phase lente.

Cette référence en fréquence permet avantageusement de diminuer la plage d'excursion des modes de résonance pour réaliser le capteur de température différentiel et être compatible des bandes allouées par la réglementation. Cela est vrai par exemple pour les bandes Industrielles, Scientifiques, Médicales désignées par les bandes ISM (appelées en anglais « Industrial, Scientific, Medical bands ») ayant une largeur de bande égale 1,7 MHz pour celle centrée en 434 MHz.

Le choix de la valeur de $\psi_2$ autour de 45° degré permet de coupler à un même degré les modes de cisaillement lent et rapide et donc d'utiliser efficacement les deux modes de cisaillement pour un capteur de température. Cette configuration est importante pour une application d'interrogation à distance où l'on cherche précisément à obtenir des contributions bien équilibrées de chaque mode pour des raisons de minimisation de la sensibilité des écarts de fréquences entre modes à l'environnement électromagnétique.

Il est à remarquer qu'il est équivalent de couper la plaque de quartz selon une couple à simple rotation $(Y_2X_2l)O_2$ avec $\theta_2$ égal à 35° ou de faire pivoter la plaque de quartz autour de la normale de la plaque de niobate de lithium de sorte que le vecteur de polarisation de cisaillement de la plaque de niobate de lithium $\vec{P}_{Acis\_dual}$ forme avec les vecteurs de polarisation de cisaillement à vitesse de phase lente et à vitesse de phase rapide $\vec{P}_{B2}$ et $\vec{P}_{B3}$ du quartz des angles de mesures sensiblement égales à 45 degrés.

En variante l'angle $\theta_2$ est compris entre -60° et 45°. Cette plage large d'angle de coupe englobe non seulement les cas dans lesquels on trouve des CTFB positifs (CTFB1) et négatifs (CTFB2) pour les modes de cisaillement respectivement lents et rapides mais également le cas où il est possible d'exciter au mois un mode stable en température au sens de la minimisation du coefficient en température de la fréquence du résonateur (CTF1). Cette plage couvre également le point de fonctionnement pour lequel les deux modes de cisaillement du substrat présentent le même coefficient de température de fréquence. Ce point de fonctionnement constitue une limite basse pour laquelle le différentiel de coefficient de température de fréquence du résonateur entre les deux modes de cisaillement est égal à 1 ppm/K$^{-1}$. Ainsi, sur cette plage angulaire de coupes à simple rotation du substrat, des différentiels de CTF du résonateur compris entre 1 ppm/K$^{-1}$ et 180 ppm/K$^{-1}$ peuvent être exploités.

En variante, l'angle $\psi_2$ dans le cas d'une coupe cristallographique $(Y_2X_2lt)/\theta_2/\psi_2$ et d'un alignement sans pivotement de la plaque de quartz par rapport à la plaque de niobate de llithium, ou de manière équivalente l'angle de pivotement de la plaque de quartz lorsque la plaque de quartz est coupée selon la coupe à simple rotation $(Y_2X_2l)/\theta_2$, est quelconque. Dans ce cas, le mode longitudinal et au moins un mode de cisaillement peuvent être utilisés pour fournir les informations d'un capteur de température différentiel.

Une méthode utilisée pour déterminer les coupes intéressantes de quartz convenant à l'obtention d'un capteur de température est la suivante.

Cette méthode est une méthode simplifiée dans le sens où elle suppose que la contribution des effets différentiels de sensibilités en température de fréquence du transducteur pour au moins deux modes de résonance, lorsque les coupes du transducteur correspondent à des couplages électroacoustiques élevés de même degré pour les au moins deux modes de résonance, est négligeable par rapport aux effets différentiels de sensibilités en température de fréquences du substrat acoustique pour les mêmes modes de résonance.

Les sensibilités en températures des ondes de volume longitudinales, de cisaillement rapide et lent sont d'abord déterminées pour toutes les orientations cristallines du quartz en $\theta_2$, $\varphi_2$ et $\psi_2$.

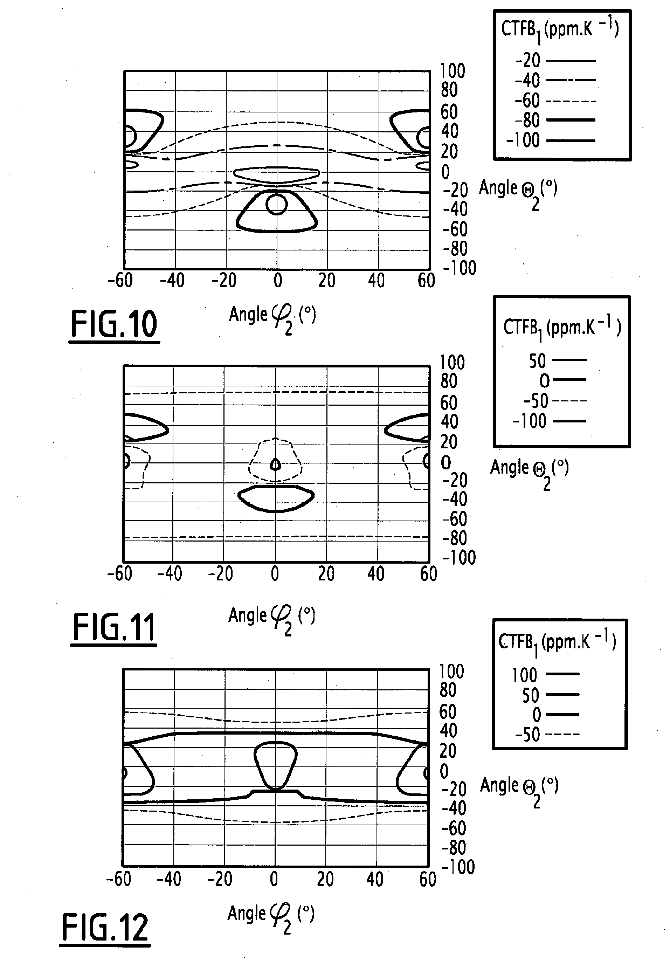

A titre d'exemple, les figures 10, 11, 12 représentent respectivement les sensibilités en température de fréquence du premier ordre CTFB1 des ondes de volume longitudinales, de cisaillement rapide et lent dans le quartz, pour toutes les orientations cristallines en $\theta_2$ et $\varphi_2$, l'angle $\psi_2$ dans ces graphiques de courbes de niveaux étant égal à zéro.

Il est à remarquer que les sensibilités différentielles du premier ordre sont représentatives de la sensibilité de détection du capteur de température en première approximation, les sensibilités d"ordre supérieures étant ensuite considérées (et plus particulièrement celles d'ordre 2) pour affiner l'estimation de température effective du capteur.

Comme cela est visible sur la figure 10, les ondes longitudinales présentent toujours un coefficient de sensibilité à la température du premier ordre CTFB1 négatif, quel que soit l'angle de coupe.

En revanche, il est visible sur les figures 11 et 12, qu'il existe des angles de coupe $\theta_2$ et $\varphi_2$ pour lesquels le coefficient de sensibilité à la température du premier ordre CTFB1 du mode de cisaillement lent ou du mode de cisaillement rapide, s'annule en changeant de signe.

Il est donc possible en particulier de déterminer de nombreux angles de coupe $\theta_2$ et $\varphi_2$ pour lesquels deux modes présentent des dérives thermiques de la fréquence CTF de signes opposés.

Ces valeurs exhaustives de sensibilités CTFB1 fonction des angles de coupes sont nécessaires à l'identification de domaines ou zones de coupes cristallines particulièrement attractives pour la recherche de structures HBAR permettant le développement d'un capteur différentiel de température ayant une sensibilité suffisante.

Il est à remarquer l'existence de symétries selon l'angle $\varphi_2$ dans le quartz qui s'expriment par les relations suivantes :

$$CTFB_1(\varphi_2,\theta_2) = CTFB_1(\varphi_2+120, \theta_2) \text{ et } CTFB_1(\varphi_2,\theta_2) = CTFB_1(-\varphi_2,\theta_2).$$

Les ondes longitudinales présentent toujours un CTFB1 négatif, alors que les modes de cisaillement possèdent des zones angulaires pour lesquelles le coefficient de sensibilité à la température du premier ordre s'annule et change donc de signe.

Le voisinage de ces orientations cristallines est d'autant plus intéressant que le mode non couplé par piézoélectricité aura forcément une dérive thermique de la fréquence de signe opposé à celui du mode couplé à proximité de ce lieu angulaire. Il existe en substance de nombreuses zones angulaires pour lesquelles deux modes peuvent exister qui présentent des dérives thermique de la fréquence de signe opposé, et donc un différentiel de sensibilité en température de fréquence supérieur ou égal à 20 ppm.K$^{-1}$.

De fait, il peut être envisagé de coupler deux modes de cisaillement ou un mode longitudinal et un mode de cisaillement, l'essentiel étant de calibrer dûment la sensibilité thermique différentielle pour obtenir un capteur de température ayant la performance souhaitée.

Cette opération nécessite donc d'établir un minimum d'abaques pour déterminer la dérive thermique découlant de la différence entre les fréquences de résonance respectivement associées aux modes exploités.

Il est à remarquer que l'examen des abaques des CTFB1 du quartz est suffisant lorsque l'angle de coupe $\theta_1$ de la plaque de niobate de lithium est compris dans la première zone 222 ou dans la zone 224.

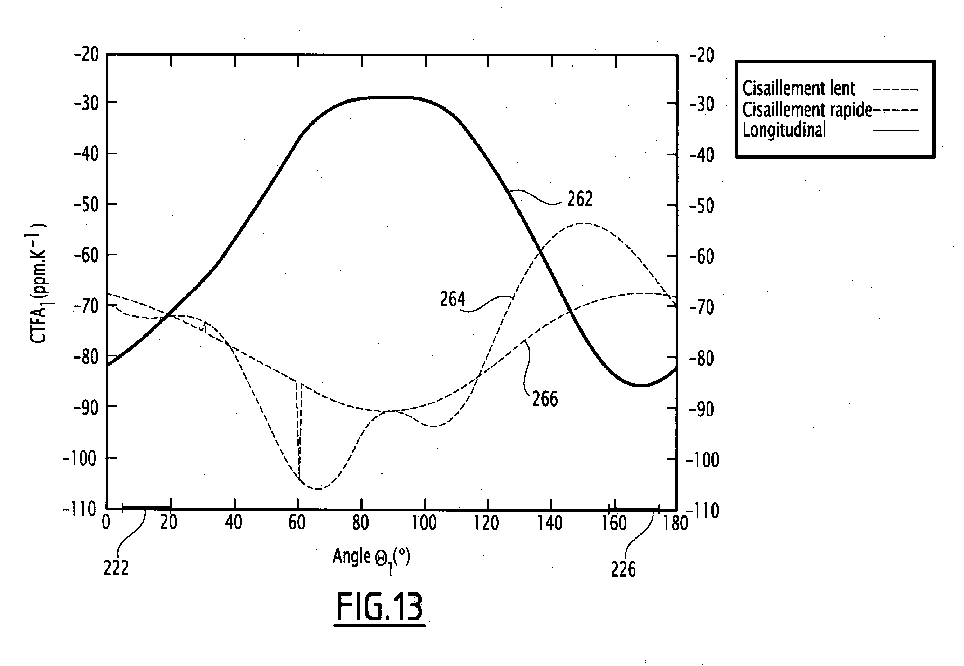

En effet, suivant la Figure 13 qui représente des courbes 262, 264, 256 d'évolution respective de la sensibilité de la température en fréquence du mode longitudinal, du mode de cisaillement rapide et du mode de cisaillement lent, il est visible que la différence des CTFA1 du niobate de lithium pour deux modes différents est inférieur à une quinzaine de ppm.K$^{-1}$.

En toute rigueur, les calculs des lois de variation des fréquences de résonance pour différents modes de vibration en fonction de la température dépendent des CTF1s du résonateur, c'est-à-dire de l'effet cumulé pour un mode donné du CTFB1 du substrat acoustique, ici du quartz et du CTFA1 du transducteur, ici le niobate de lithium.

Ainsi pour un couple de matériaux choisis pour le transducteur 10 et le substrat acoustique 12, il convient de disposer des abaques des CTF du transducteur 10 et du substrat acoustique 12 et de sélectionner des couples d'orientations cristallographiques transducteur/substrat acoustique tels que la différence des CTF cumulés du premier ordre, associés à l'ensemble formé par le transducteur et le substrat, entre un premier mode de vibration et un deuxième mode de vibration, soit supérieur ou égal à 1 ppm.K$^{-1}$.

En première approximation, le premier coefficient de température de la fréquence du résonateur 10 du premier ordre CTF1, associé au premier mode de vibration, est égal à la somme du premier coefficient de température de la fréquence du substrat 14 du premier ordre CTFB1 et du premier coefficient de température de la fréquence de transducteur 12 du premier ordre CTFA1 pondéré par les épaisseurs relatives de chaque matériau par rapport à l'épaisseur totale du résonateur. Cette approximation se traduit par l'équation : CTF1= (CTFA1*$t_1$ + CTFB1*$t_2$)/($t_1$+$t_2$).

En première approximation, le deuxième coefficient de température de la fréquence du résonateur 10 du premier ordre CTF1, associé au deuxième mode de vibration, est égal à la somme du deuxième coefficient de température de la fréquence du substrat 14 du premier ordre CTFB2 et du deuxième coefficient de température de la fréquence de transducteur 12 du premier ordre CTFA2 pondéré par les épaisseurs relatives de chaque matériau par rapport à l'épaisseur totale du résonateur. Cette approximation se traduit par l'équation : CTF2= (CTFA2*$t_1$ + CTFB2*$t_2$)/($t_1$+$t_2$).

Ces approximations sont valides lorsque le rapport de la première épaisseur $t_1$ sur la deuxième épaisseur $t_2$ est inférieur ou égal à 0,05.

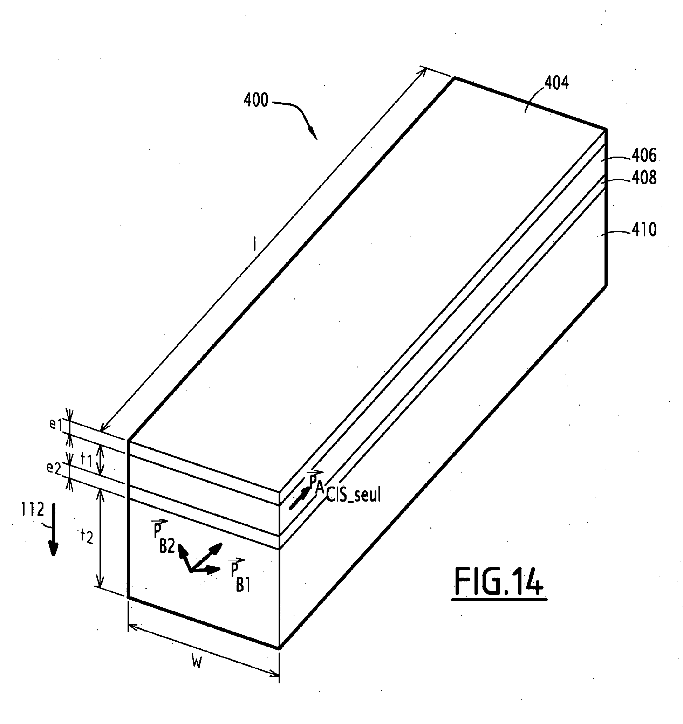

Suivant la Figure 14, une deuxième forme de réalisation 400 d'un résonateur 10 de type à ondes de volume à harmoniques élevées HBAR du capteur de température 2 de la Figure 1, comprend un empilement de couches successives, identiques en termes de matériaux et d'épaisseurs de couches $e_1$, $e_2$, $t_1$, $t_2$ utilisés à ceux décrits dans les Figures 2 et 3, mais différents en ce qui concernent les orientations cristallographiques du transducteur 12 et du substrat acoustique 14 désignés ici respectivement par les références 406 et 410.

Le transducteur piézoélectrique 406 est ici configuré pour présenter un mode de polarisation unique $\vec{P}_{Acis\_seul}$ correspondant à un mode de vibration de cisaillement du transducteur 406 et tel que le coefficient de couplage électroacoustique $K_T^2$ de l'onde de cisaillement est supérieur ou égal à 5%.

Dans cette configuration de coupe de niobate de lithium, le mode de vibration longitudinale est inexistant ou tout du moins négligeable par rapport au mode de vibration transversal.

De manière préférée, la coupe de niobate de lithium est une coupe à simple rotation $(Y_1X_1l)/\theta_1$ dans laquelle l'angle de coupe $\theta_1$ est compris dans la deuxième zone 224 décrite à la Figure 7, c'est à dire compris entre 158° et 168°.

De manière préférée, l'angle de coupe $\theta_1$ est compris entre 163 et 165°. Dans ce cas, seules les ondes de cisaillement rapides sont couplées dans le niobate de lithium.

Le substrat acoustique 410 est configuré pour présenter deux modes de polarisation transverses ou de cisaillement, un premier mode de vibration polarisée transversalement à vitesse de phase lente, représenté par un premier vecteur de polarisation $\vec{P}_{B1}$ de direction orthogonale à la direction de polarisation 112, et un deuxième mode de vibration polarisée transversalement à vitesse de phase rapide représenté par un deuxième vecteur de polarisation $\vec{P}_{B2}$ orthogonal au premier vecteur de polarisation $\vec{P}_{B1}$ et à la direction de propagation 112.

Ici, le substrat acoustique 410 est une plaque de quartz découpée selon une coupe à simple rotation $(Y_2X_2l)/\theta_2$ voisine ou égale à la coupe connue et habituellement notée AT de quartz, c'est-à-dire $(Y_2X_2l)/35°$, coupe pour laquelle le coefficient CTFB1 du mode de cisaillement lent est positif ou nul et celui du mode de cisaillement rapide négatif.

La plaque de niobate de lithium 406 et la plaque de quartz 410 sont ensuite agencées l'une par rapport à l'autre de sorte que les modes de cisaillement lent et rapide soient excités simultanément et de préférence à un même niveau d'efficacité. A cet effet, on place la plaque de niobate de lithium de sorte que les axes $Z'_i$, (c'est-à-dire les axes cristallographiques $Z_i$ tournés autour de $Y'_i$, la normale à la plaque) respectifs du niobate de lithium (i égal à 1) et du quartz (i égal à 2) forment ensemble un angle de 45°.

De manière équivalente, il est rappelé qu'une plaque de quartz ayant une coupe à double rotation de type $(Y_2X_2lt)/\theta_2/45°$ et superposée sans pivotement d'angle $\psi$ sur la plaque de niobate de lithium ayant une coupe $(Y_1X_1l)/163°$, produit le même effet que celui de deux coupes à simple rotation, une coupe $Y_2X_2l/\theta_2$ pour le quartz et une coupe $(Y_1X_1l)/163°$ pour le niobate de lithium, pivotées entre elles d'un angle de pivotement à la superposition de 45°.

Ainsi, pour exciter plusieurs modes de vibration simultanément, il est possible d'utiliser du quartz à orientation de coupe à double rotation, ou à simple rotation en adaptant l'alignement cristallographique du transducteur et du substrat en fonction de l'excitation de mode recherchée.

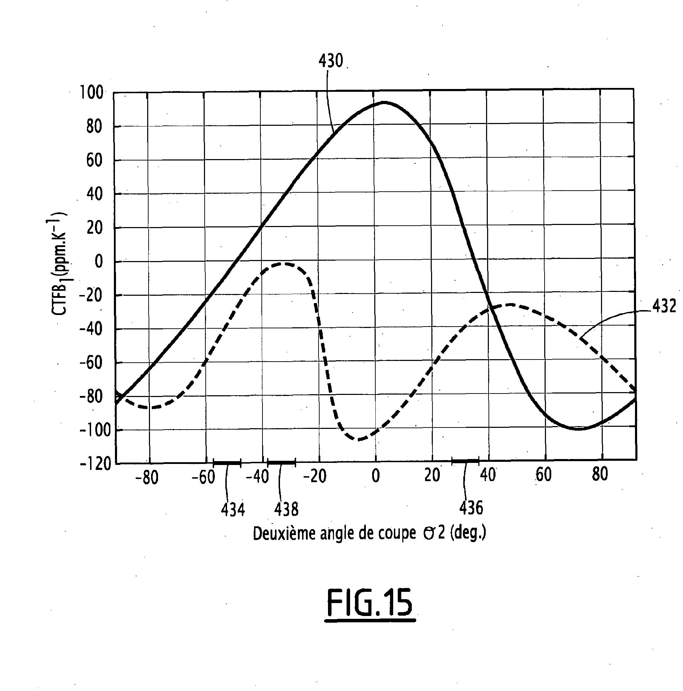

Suivant la Figure 15, la sensibilité aux effets thermiques statiques des modes de cisaillement du quartz coupé selon la coupe à simple rotation $(Y_2X_2l)/\theta_2$ est représentée sous forme de deux coefficients de température de la fréquence du premier ordre CTFB1 et CTFB2 pour un substrat acoustique 310 exprimé en $ppm.K^{-1}$ (partie par millions de la fréquence par Kelvin), en fonction du deuxième angle de couple $\theta_2$ exprimé en degrés.

Une première courbe 430 en trait plein représente l'évolution d'un premier coefficient de température de la fréquence du premier ordre CTFB1 pour les ondes de cisaillement dites lentes en fonction du deuxième angle de couple $\theta_2$.

Une deuxième courbe 432 en traits pointillés représente l'évolution d'un deuxième coefficient de température de la fréquence du premier ordre CTFB2 pour les ondes de cisaillement dites rapides en fonction du deuxième angle de couple $\theta_2$.

Les ondes de cisaillement dites rapides ou de mode rapide et les ondes de cisaillement dites lentes ou de mode lent sont définies comme des ondes de cisaillement de polarisation orthogonale, les ondes dites rapides ayant une vitesse de phase supérieure aux ondes dites lentes.

La courbe 430 montre l'existence d'une zone angulaire 434 dans laquelle le premier coefficient de température de la fréquence du premier ordre CTFB1 pour les ondes de cisaillement lentes est égal à zéro avec inversion de signe de part et d'autre. La zone angulaire 432 est centrée autour de l'angle de coupe $\theta_2$ égal à -48 degrés (couramment appelé angle de coupe BT) et présente une amplitude de 22 degrés garantissant ainsi un premier coefficient de température de la fréquence du premier ordre CTFB1 inférieur en valeur absolue à 20 $ppm.K^{-1}$. Un différentiel de CTFB (CTFB1-CTFB2) entre le mode lent et le mode rapide est supérieur à 20 $ppm.K^{-1}$ garantissant en pratique une sensibilité du capteur de température de l'ordre du différentiel de CTFB, donc dans tous les cas une sensibilité supérieure ou égal à 5 $ppm.K^{-1}$.

La courbe 430 montre également l'existence d'une zone angulaire 436 dans laquelle le premier coefficient de température de la fréquence du premier ordre CTFB1 pour les ondes de cisaillement lentes est égal à zéro avec inversion du signe de par et d'autre. La zone angulaire 436 est centrée autour de l'angle de coupe $\theta_2$ égal à +35 degrés (couramment appelé angle de coupe AT) et présente une amplitude de 10 degrés garantissant ainsi un premier coefficient de température de la fréquence du premier ordre CTFB1 inférieur en valeur absolue à 20 $ppm.K^{-1}$. Un différentiel de CTFB (CTFB1-CTFB2) pour le quartz entre le mode lent et le mode rapide est supérieur à 10 $ppm.K^{-1}$ garantissant une sensibilité du capteur de température supérieur ou égal à 5 $ppm.K^{-1}$.

La courbe 430 montre également l'existence d'une zone angulaire 438 dans laquelle le premier coefficient de température de la fréquence du premier ordre CTFB1 pour les ondes de cisaillement lentes est proche de zéro et s'en approche de manière douce. La zone angulaire 438 est centrée autour de l'angle de coupe $\theta2$ égal à -32 degrés et présente une amplitude de 20 degrés garantissant ainsi un premier coefficient de température de la fréquence du premier ordre CTFB1 inférieur en valeur absolue à 20 $ppm.K^{-1}$. Un différentiel de CTFB (CTFB1-CTFB2) pour le quartz entre le mode lent et le mode rapide est supérieur à 30 $ppm.K^{-1}$ garantissant une sensibilité du capteur de température supérieur ou égal à 5 $ppm.K^{-1}$.

L'avantage de travailler au voisinage des points de compensation, c'est-à-dire dans les zones 434, 436, 438 est d'optimiser l'étendue de la bande de fréquence de travail. Ce point est crucial pour les applications sans fil (« wireless ») où l'étendue de la bande ISM (1,7 MHz à 434 MHz, 0,85 MHz à 868 MHz et 80 MHz à 2,45 GHz) réduit les degrés de liberté en terme d'excursion spectrale de la fréquence en fonction de la température.

La courbe 432 quant à elle montre que le second coefficient de température de la fréquence du premier ordre CTFB2 pour les ondes de cisaillement rapides, reste négatif.

Lorsque le deuxième angle $\theta_2$ du substrat acoustique est choisi entre -48 et 35 degrés (voir Figure 15), sur cet intervalle, le premier coefficient en température de la fréquence du premier ordre CTFB1 pour les ondes de cisaillement lentes et le second coefficient en température de la fréquence du premier ordre CTFB2 pour les ondes de cisaillement rapides, sont de signes opposés.

Lorsque l'angle de coupe l'angle $\theta_1$ du transducteur 406 est choisi dans la zone 22 (voir Figure 8) et que le deuxième angle $\theta_2$ du substrat acoustique est compris entre - 48 et 35 degrés, le différentiel de sensibilité en température de fréquence (CTFB1-CTFB2) est supérieur ou égal à 25 $ppm.K^{-1}$, et la sensibilité du capteur est supérieur ou égal à 20 $ppm.K^{-1}$.

Il est à remarquer que lorsque l'angle de coupe $\theta_2$ du quartz est choisi entre -10 et 10°, la différence entre le premier coefficient de température de la fréquence du premier ordre CTFB1 pour les ondes de cisaillement lentes et le second coefficient de température de la fréquence du premier ordre CTFB2 pour les ondes de cisaillement rapides est maximale sur cet intervalle, supérieure à 100 $ppm.K^{-1}$, ce qui permet de constituer un capteur de température à très haute résolution.

Il est également à remarquer que lorsque l'angle de coupe $\theta2$ du quartz est choisi entre 35° et 45°, la différence entre le premier coefficient de température de la fréquence du premier ordre CTFB1 pour les ondes de cisaillement lentes et le second coefficient de température de la fréquence du premier ordre CTFB2 pour les ondes de cisaillement rapides varie sur cet intervalle de 40 à 1 $ppm.K^{-1}$, ce qui permet d'ajuster finement la valeur du différentiel pour couvrir, en particulier dans le cas de applications sans fil, des gammes de températures étendues malgré les restrictions spectrales liées aux normes gouvernant de telles applications, en particulier les normes de rayonnement ISM.

Par example, pour mesurer la température sur une gamme de 200°C avec un capteur différentiel dans la bande ISM centrée en 434 MHZ de largeur 1,7 MHz ne prévoyant de larges zones de fréquences de garde aux limites hautes et basses de la bande exploitée pour respecter les normes, la sensibilité différentielle doit être ici de l'ordre de 10 ppm.K$^{-1}$. Dans d'autres exemples, des sensibilités différentielles de faibles valeurs allant jusqu'à 1 ppm.K$^{-1}$ peuvent être requises.

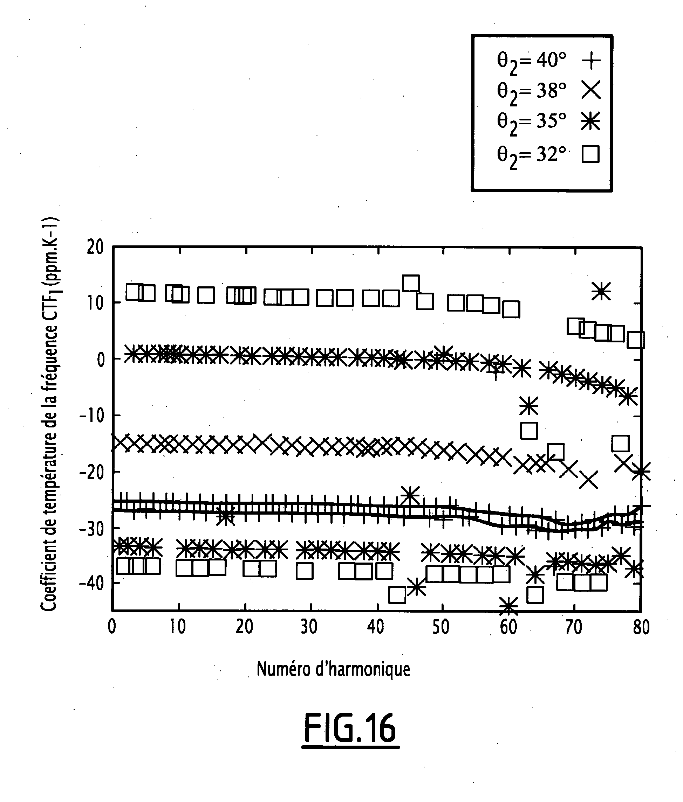

La Figure 16 montre l'évolution de l'écart des sensibilités en température de fréquence du résonateur CTF1 entre les deux modes transversaux excités en fonction de l'angle de coupe de quartz $\theta_2$ dans le cas d'un empilement de niobate de lithium $(Y_1X_1l)/165°$ sur quartz $(Y_2X_2lt)/\theta2/45°$ avec $\theta_2$ variant de 32° à 40° pour un rapport de 1 $\mu$m de niobate sur 50 $\mu$m de quartz.

Le différentiel de sensibilité thermique entre les deux modes excitables dans cette structure est bien conforme à celui de la Figure 15 et suit pour une épaisseur de niobate nettement inférieure à celle du substrat de quartz, c'est-à-dire un rapport d'épaisseur niobate de lithium/quartz inférieur ou égal à 5%, la loi de température de ce dernier matériau.

On décrit ci-dessous un exemple particulier de configuration du deuxième mode de réalisation, destiné à une application sans fil, pour laquelle il est préférable d'adapter la structure à un fonctionnement dans la bande ISM, correspondant aux bandes de fréquences pouvant être utilisées librement pour des applications industrielles, scientifiques ou médicales.

Afin de déterminer une telle configuration, on choisit tout d'abord, par exemple, une coupe de quartz $(X_2Y_2lt)$ 35°/45° de 100 $\mu$m d'épaisseur, associée à une plaque de niobate (YXl)/165° de 3 $\mu$m d'épaisseur. On choisit également de travailler dans la bande ISM centrée en 433,9 MHz, avec un étalement de bande égal à 1,7 MHz. Les deux modes de cisaillement de la coupe de quartz choisie présentent des vitesses de phase respectives proches de V1 égale à 3240 m/s et V2 égale à 3700 m/s.

Pour localiser les modes de vibrations dans une bande de fréquence étroite, il faut pouvoir exciter des harmoniques dont le rapport d'ordres s'approche du rapport des vitesses des modes, soit 1,142. Il faut donc un rapport d'ordres harmoniques donnant une valeur la plus proche possible de celle-ci, par exemple 8/7 égal à 1,1428.

Ainsi, pour un empilement respectant le rapport des épaisseurs de couche de l'empilement, ici un rapport d'épaisseurs de couche de niobate/couche de quartz égal à 0,01, tous les modes dont le rapport d'ordres peut se ramener à 8/7, par exemple 16/14, 24/21, satisferont le critère énoncé.

On choisit alors l'ordre d'un des deux modes et sa fréquence de travail afin de déterminer l'épaisseur de la plaque de quartz, sachant que la démarche proposée n'a de sens que si le rapport de l'épaisseur du transducteur sur l'épaisseur de la plaque de quartz est inférieur ou égal à 0,05.

Par exemple, pour une fréquence de travail F1 égale à 434 MHz, et les modes d'ordre 8 (N1) et 7 (N2), en considérant le mode lent, on trouve une épaisseur de t2 égal à 0,5.N1.V1/F1, c'est-à-dire égal à 29,78 $\mu$m. On peut ensuite calculer les épaisseurs relatives de quartz et de niobate, respectivement t2 égal à 28,86 $\mu$m et t1 égal à 0,86 $\mu$m.

On notera que le calcul avec le second mode donne un résultat similaire : $t2=0,5.N_2.V_2/F_2=29,79$ $\mu$m.

En pratique, on voit qu'un ajustage manuel des épaisseurs est nécessaire pour ajuster les deux modes dans la bande ISM comme souhaité. Les valeurs pratiques adoptées sont de 29,15 $\mu$m pour la couche de quartz et de 1 $\mu$m pour le niobate, toujours compte tenu des deux électrodes en aluminium et en or de 100 nm d'épaisseur chacune, soit un ajustement d'épaisseur inférieur à 2% de la valeur nominalement prévue. Ceci s'explique par le besoin de ramener la dérive dans la bande ISM sur toute la gamme de température. On obtient ce résultat en modifiant sensiblement la coupe de quartz, qui vaut maintenant 36,5°. Cette correction n'a été nécessaire que pour la qualité de l'illustration de l'approche.

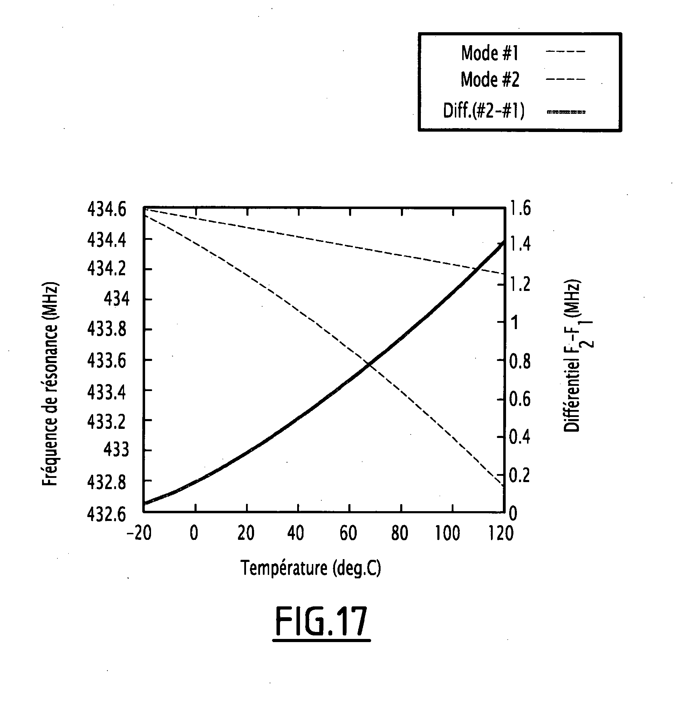

La Figure 17 montre les résultats obtenus sous forme de courbes de fréquences de résonance en fonction de la température. On voit les deux fréquences bien localisées dans la bande ISM jusqu'à 100 °C avec un usage optimal de la bande autorisée. On voit toutefois que le différentiel des fréquences de résonance est quadratique, ce qui impose un calcul de la température en fonction des coefficients de sensibilité. Ici, une loi de comportement du différentiel de fréquence tel que $\Delta F=0,1+7,5.10^{-3}\times T+2,5.10^{-5}\times T^2$ en MHz est obtenue avec T la température en degrés. Cette approche peut être menée avec des harmoniques d'ordre plus élevé pour alléger la contrainte en épaisseur de couches et optimiser le coefficient de couplage de chaque mode.

En variante, le matériau dans lequel est réalisé le transducteur est choisi parmi le nitrure d'aluminium (AlN), l'oxyde de zinc (ZnO), le tantalate de lithium (LiTaO3), le niobate de potassium, le PZT, le PbTiO3, et de façon générale les céramiques piézoélectriques à fort couplage électromécanique.

En variante, le matériau dans lequel est réalisé le substrat est choisi parmi le quartz, le niobate de potassium, la tantale de lithium, l'orthophosphate de gallium, le tétraborate de lithium, la langasite, le langatate et la langanite.

Pour un couple donné de matériaux décrits ci-dessus, constituant respectivement le transducteur et le substrat acoustique, les coupes cristallographiques et les positionnements relatifs des plaques sont déterminés de manière analogue à ce qui été décrit ci-dessus de sorte à obtenir des dérives différentielles de fréquences aux bornes de la paire d'électrodes enserrant le transducteur.

**Revendications**

1. Capteur de température comprenant un résonateur (10) de type à ondes de volumes à modes harmoniques élevées HBAR destiné à travailler à une fréquence de travail prédéterminée et dans une plage de température centrée autour d'une température de référence $T_0$, le résonateur (10) comportant :

   - un transducteur piézoélectrique (12, 106 ; 406) constitué par une couche d'une première épaisseur d'un premier matériau, coupé selon un premier angle de coupe de transducteur $\varphi_1$ défini par la nomenclature (YXw)/$\varphi$ du standard IEEE Std -176 (révision 1949) égal sensiblement à zéro, et coupé selon un deuxième angle de coupe $\theta_1$ de transducteur défini par la nomenclature (YXl)/$\theta$ du standard IEEE Std -176 (révision 1949), tels que le transducteur piézoélectrique (12 ; 106 ; 406) présente, soit une première direction de polarisation $\vec{P}_{Along}$ d'un premier mode de vibration longitudinal du transducteur (12 ; 106 ; 406), et une deuxième direction de polarisation $\vec{P}_{Acis\_dual}$ d'un deuxième mode de vibration de cisaillement du transducteur piézoélectrique (2 ;106 ; 406), soit une direction unique de polarisation $\vec{P}_{Acis\_seul}$ correspondant à un mode de vibration de cisaillement du transducteur, et tel que le couplage électroacoustique d'une vibration de cisaillement et/ou d'une vibration longitudinal pour le matériau du transducteur est supérieur ou égal à 5%,
   - un substrat acoustique (14 ; 110 ; 410) constitué par une couche d'une deuxième épaisseur d'un deuxième matériau ayant un produit coefficient de qualité acoustique - fréquence d'excitation au moins égal à $5.10^{12}$, coupé selon un premier angle de coupe de substrat $\theta_2$ défini par la nomenclature (YXl)/$\theta$ du standard IEEE Std-176 (révision 1949), coupé selon un deuxième angle de coupe de substrat $\psi_2$ défini par la nomenclature (YXt)/$\psi$ du standard IEEE Std-176 (révision 1949), présentant aux moins deux directions de polarisation parmi une première direction de polarisation $\vec{P}_{B1}$, une deuxième direction de polarisation $\vec{P}_{B2}$, une troisième direction de polarisation $\vec{P}_{long}$, correspondant respectivement à un mode de vibration, de cisaillement du substrat (14 ; 110 ; 410) à vitesse de phase lente, à un mode de vibration, de cisaillement du substrat à vitesse de phase rapide, et à un mode de vibration longitudinal du substrat,
   - une contre électrode (19 ; 108 ; 408) formée par une couche de métal collant une première face du transducteur piézoélectrique (12 ; 106 ; 406) et une face du substrat acoustique (14 ; 110; 410), et
   - une électrode supérieure (18 ; 104 ; 404) disposée sur une deuxième face du transducteur piézoélectrique (12 ; 106 ; 406) opposée à la première face du transducteur piézoélectrique (12 ; 106 ; 406) et au substrat (14 ; 110 ; 410),

   **caractérisé en ce que**
   le rapport de la première épaisseur sur la deuxième épaisseur est inférieur ou égal à 0,05;
   les angles de coupe $\varphi_1$, $\theta_1$, $\psi_2$, $\theta_2$, et la disposition relative du transducteur piézoélectrique (12 ; 106 ; 406) et du substrat (14 ; 110 ; 410) sont configurés de sorte
   qu'il existe simultanément au moins deux modes de vibration du substrat (14 ; 110 ; 410) couplés fortement à un même degré à au moins un mode de vibration du transducteur piézoélectrique (12 ; 106 ; 406), et que
   les au moins deux modes de vibration du substrat (14 ; 110 ; 410) fortement couplés comprennent un premier mode de vibration ayant un premier coefficient de température de la fréquence de substrat du premier ordre à la température de référence $T_0$ et un deuxième mode de vibration du substrat ayant un deuxième coefficient de température de la fréquence de substrat du premier ordre à la même température de référence, et
   le transducteur (14 ; 110 ; 410), pour le premier mode de vibration du substrat, possède un premier coefficient de température de la fréquence de transducteur du premier ordre à la température de référence, et possède pour le deuxième mode de vibration du substrat, un deuxième coefficient de température de la fréquence de transducteur du premier ordre à la température de référence, et
   la valeur absolue de la différence d'un premier et d'un deuxième coefficients de température de la fréquence du résonateur (10) du premier ordre est supérieure ou égale à 1 ppm/°K,
   le premier coefficient de température de la fréquence du résonateur (10) du premier ordre étant sensiblement égal à la somme du premier coefficient de température de la fréquence du substrat (14 ; 110 ; 410) du premier ordre et du premier coefficient de température de la fréquence de transducteur piézoélectrique (12 ; 106 ; 406) du premier ordre pondéré par les épaisseurs relatives de chaque matériau par rapport à l'épaisseur totale du résonateur, et
   le deuxième coefficient de température de la fréquence du résonateur (10) étant sensiblement égal à la somme du deuxième coefficient de température de la fréquence du substrat (14 ; 110 ; 410) du premier ordre et du deuxième coefficient de température de la fréquence de transducteur piézoélectrique (12 ; 106 ; 406) du premier ordre pondéré par les épaisseurs relatives de chaque matériau par rapport à l'épaisseur totale du résonateur.

2. Capteur de température selon la revendication 1, **caractérisé en ce que**

le transducteur piézoélectrique (106) est coupé selon une coupe à simple rotation $(X_1 Y_1 l)/\theta_1$ tel que le transducteur (106) présente une première direction de polarisation $\vec{P}_{Along}$ d'un premier mode de vibration longitudinal du transducteur et une deuxième direction de polarisation $\vec{P}_{Acis\_dual}$ d'un deuxième mode de vibration de cisaillement du transducteur, et tel que le couplage électroacoustique d'une onde à mode de cisaillement et d'une onde à mode longitudinal pour ce matériau, est supérieur à 5%, et

les angles de coupe $\theta_1$, $\psi_2$, $\theta_2$, et la disposition relative du transducteur (106) et du substrat acoustique (110) sont configurés de sorte

qu'il existe simultanément trois modes de vibration du substrat couplés fortement à un même degré à un des deux modes de vibration du transducteur, et que

les trois modes de vibration du substrat fortement couplés comprennent un premier mode de vibration du substrat à cisaillement lent, polarisé suivant $\vec{P}_{B1}$ et ayant un premier coefficient de température de la fréquence de substrat du premier ordre à la température de référence, un deuxième mode de vibration du substrat à cisaillement rapide, polarisé suivant $\vec{P}_{B2}$ et ayant un deuxième coefficient de température de la fréquence de substrat du premier ordre à la température de référence, et un troisième mode de vibration longitudinal, polarisé suivant $\vec{P}_{long}$ et ayant un premier coefficient de température de la fréquence de substrat du premier ordre à la température de référence,

le transducteur (106) pour les premier, deuxième, troisième modes de vibration du substrat, possède respectivement un premier, un deuxième, un troisième coefficients de température de la fréquence de transducteur du premier ordre à la température de référence,

la valeur absolue de la différence de deux quelconques coefficients de température de la fréquence du résonateur (10) du premier ordre d'un ensemble formé par un premier, un deuxième, et un troisième coefficients de température de la fréquence du résonateur du premier ordre, est supérieure ou égale à 1 ppm/°K,

le premier coefficient de température de la fréquence du résonateur (10) du premier ordre est sensiblement égal à la somme du premier coefficient de température de la fréquence du substrat du premier ordre et du premier coefficient de température de la fréquence de transducteur du premier ordre pondéré par les épaisseurs relatives de chaque matériau par rapport à l'épaisseur totale du résonateur, et

le deuxième coefficient de température de la fréquence du résonateur (10) étant sensiblement égal à la somme du deuxième coefficient de température de la fréquence du substrat du premier ordre et du deuxième coefficient de température de la fréquence de transducteur du premier ordre pondéré par les épaisseurs relatives de chaque matériau par rapport à l'épaisseur totale du résonateur, et

le troisième coefficient de température de la fréquence du résonateur étant sensiblement égal à la somme du troisième coefficient de température de la fréquence du substrat du premier ordre et du troisième coefficient de température de la fréquence de transducteur du premier ordre pondéré par les épaisseurs relatives de chaque matériau par rapport à l'épaisseur totale du résonateur.

3. Capteur de température selon la revendication 1, **caractérisé en ce que**

le transducteur piézoélectrique (106) est coupé selon une coupe à simple rotation $(X_1 Y_1 l)/\theta_1$ telle que le transducteur (106) présente une première direction de polarisation $\vec{P}_{Along}$ d'un premier mode de vibration longitudinal du transducteur et une deuxième direction de polarisation $\vec{P}_{Acis\_dual}$ d'un deuxième mode de vibration de cisaillement du transducteur, et telle que le couplage électroacoustique d'une onde à mode de cisaillement et d'une onde à mode longitudinal pour ce matériau est supérieur à 5%, et

les angles de coupe $\varphi_1$, $\theta_1$, $\psi_2$, $\theta_2$, et la disposition relative du transducteur (106) et du substrat (110) sont configurés de sorte

qu'il existe simultanément seulement deux modes de vibration du substrat couplés fortement à un même degré à un des deux modes de vibration du transducteur (106), et que

les deux modes de vibration du substrat fortement couplés comprennent un premier mode de vibration du substrat à cisaillement ayant un premier coefficient de température de la fréquence de substrat du premier ordre à la température de référence, un deuxième mode de vibration longitudinal ayant un deuxième coefficient de température de la fréquence de substrat du premier ordre à la température de référence

le transducteur (106) pour les premier, deuxième modes de vibration possède respectivement un premier, un deuxième coefficients de température de la fréquence de transducteur du premier ordre à la température de référence,

la valeur absolue de la différence d'un premier et d'un deuxième coefficients de température de la fréquence du résonateur du premier ordre est supérieure ou égale à 1 ppm/°K,

le premier coefficient de température de la fréquence du résonateur du premier ordre étant sensiblement égal à la somme du premier coefficient de température de la fréquence du substrat du premier ordre et du premier coefficient de température de la fréquence de transducteur du premier ordre pondérée par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat du premier ordre et du deuxième coefficient de température de la fréquence de transducteur du premier ordre pondérée par les épaisseurs relatives de chaque matériau par rapport à l'épaisseur totale du résonateur.

**4.** Capteur de température selon la revendication 1, **caractérisé en ce que**
le matériau du transducteur piézoélectrique (106) est du niobate de litihium ou du tantalate de litihum et le transducteur (106) est coupé selon une coupe à simple rotation $(Y_1X_1l)/\theta_1$ dans laquelle l'angle de coupe $\theta_1$ est un angle compris entre 0°et 25°.

**5.** Capteur de température selon la revendication 1, **caractérisé en ce que**
le transducteur piézoélectrique (406) est coupé selon une coupe à simple rotation $(X_1Y_1l)/\theta_1$ telle que le transducteur (406) présente une direction unique de polarisation $\vec{P}_{Acis\_seul}$ correspondant à un mode de vibration de cisaillement du transducteur, et telle que le couplage électroacoustique d'une vibration de cisaillement et/ou d'une vibration longitudinale pour le matériau du transducteur (406) est supérieur ou égal à 5%,

les angles de coupe $\theta_1$, $\psi_2$, $\theta_2$, et la disposition relative du transducteur (406) et du substrat (410) sont configurés de sorte

qu'il existe simultanément deux modes de vibration à cisaillement à vitesses de phase différentes, couplés fortement à un même degré au mode de vibration transversal du transducteur, et que

les deux modes de vibration du substrat fortement couplés comprennent un premier mode de vibration du substrat (410) à cisaillement lent ayant un premier coefficient de température de la fréquence de substrat du premier ordre à la température de référence, un deuxième mode de vibration à cisaillement rapide du substrat ayant un deuxième coefficient de température de la fréquence de substrat du premier ordre à la température de référence

l'angle formé entre la direction unique de polarisation de cisaillement du transducteur (406) et la direction de polarisation de cisaillement à vitesse de phase lente du substrat (410), et l'angle formé entre la direction unique de polarisation de cisaillement du transducteur (406) et la direction de polarisation de cisaillement à vitesse de phase rapide du substrat (410) sont sensiblement égaux et de mesure égale à 45 degrés ;

le transducteur (406) pour les premier, deuxième modes de vibration possède respectivement un premier, un deuxième coefficients de température de la fréquence de transducteur du premier ordre à la température de référence,

la valeur absolue de la différence d'un premier et d'un deuxième coefficients de température de la fréquence du résonateur du premier ordre est supérieure ou égale à 1 ppm/°K,

le premier coefficient de température de la fréquence du résonateur du premier ordre étant sensiblement égal à la somme du premier coefficient de température de la fréquence du substrat du premier ordre et du premier coefficient de température de la fréquence de transducteur du premier ordre pondérée par les épaisseurs relatives de chaque matériau par rapport à l'épaisseur totale du résonateur, et

le deuxième coefficient de température de la fréquence du résonateur étant sensiblement égal à la somme du deuxième coefficient de température de la fréquence du substrat (410) du premier ordre et du deuxième coefficient de température de la fréquence du transducteur (406) du premier ordre pondérée par les épaisseurs relatives de chaque matériau par rapport à l'épaisseur totale du résonateur.

**6.** Capteur de température selon la revendication 5, **caractérisé en ce que**
le matériau du transducteur piézoélectrique (406) est du niobate de litihium ou du tantalate de lithium et le transducteur (406) est coupé selon une coupe à simple rotation $(Y_1X_1l)/\theta_1$ dans laquelle l'angle de coupe $\theta_1$ est un angle compris entre 155 et 176°.

**7.** Capteur de température selon l'une quelconque des revendications 1 à 6, **caractérisé en ce qu'**un premier coefficient de température de la fréquence du substrat acoustique (14; 110; 410) est sensiblement nul ou de signe opposé au deuxième coefficient de température de la fréquence du substrat (14 ; 110 ; 410).

**8.** Capteur de température selon l'une quelconque des revendications 1 à 6, **caractérisé en ce que** la coupe du substrat est telle que le coefficient de température de la fréquence du premier ordre correspondant à l'au moins un mode de cisaillement du substrat est sensiblement nul avec inversion de son signe de part et d'autre d'un angle définissant la coupe du substrat.

**9.** Capteur de température selon l'une quelconque des revendications 1 à 6, **caractérisé en ce que** le coefficient de température de la fréquence du premier ordre du substrat correspondant à l'au moins un des modes de cisaillement du substrat est un extrémum local en valeur absolue inférieur à 20 ppm.K$^{-1}$ et la variation du coefficient de température au voisinage de cet extrémum est une variation douce inférieure en valeur absolue à 2 ppm.K$^{-1}$/degré.

10. Capteur de température selon l'une quelconque des revendications 1 à 9, dans lequel
le matériau du transducteur piézoélectrique (12 ; 106 ; 406) est choisi parmi le nitrure d'aluminium (AlN), l'oxyde de zinc (ZnO), le niobate de lithium (LiNbO$_3$), le tantalate de lithium (LiTaO$_3$), le niobate de potassium, le PZT, le PbTiO3 et les céramiques piézoélectriques à fort couplage électromécanique, et
dans lequel le matériau du substrat acoustique (14 ; 110 ; 410) est choisi parmi le quartz, le niobate de potassium, la tantalate de lithium, l'orthophosphate de gallium, le tétraborate de lithium, la langasite, la langatate et la langanite.

11. Capteur de température selon l'une quelconque des revendications 1 à 10, dans lequel la contre-électrode (19 ; 108 ; 408) est un métal thermo-compressible, par exemple l'or, le cuivre ou l'indium et l'électrode supérieure est réalisée par exemple en aluminium.

12. Capteur de température selon l'une quelconque des revendications 1 à 11, **caractérisé en ce que**
le transducteur piézoélectrique (12 ; 106 ; 406) est réalisé en niobate de lithium ; et
le matériau du substrat acoustique (14 ; 110 ; 410) est du quartz et le substrat acoustique est coupé selon une coupe à simple rotation dans laquelle l'angle de coupe $\varphi_2$ est nul, et $\theta_2$ est un angle compris entre -60 et 45 degrés.

13. Capteur de température selon la revendication 12, dans lequel l'angle de couple $\theta_1$ de la coupe $(Y_1X_1l)/\theta_1$ du niobate de litihium est choisi dans un intervalle compris entre 160 et 170°, de préférence 163°, et l'angle de coupe $\theta_2$ de la coupe $(Y_2X_2l)/A_2$ du substrat acoustique est choisi entre -48 et 35 degrés.

14. Capteur de température selon la revendication 12, dans lequel l'angle de coupe $\theta_2$ de la coupe $(Y_2X_2l)/\theta_2$ du substrat acoustique (110 ; 410) est choisi entre -10 et 10°.

15. Capteur de température selon l'une quelconque des revendications 1 à 14, comprenant une unité (20) de détermination de la différence entre une première fréquence de résonance et une deuxième fréquence de résonance du résonateur HBAR à une température T régnant au sein du résonateur, mesurées entre les deux électrodes de la même paire du résonateur, et
une unité de détermination (30) de la température T du résonateur à partir de la différence de fréquences déterminée et d'une fonction biunivoque de correspondance entre la température et la différence de fréquences.

**Patentansprüche**

1. Temperatursensor mit einem Resonator (10) des Typs mit hohen harmonischen Oberschwingungswellenvolumina HBAR *(High Overtone Bulk Acoustic Resonator),* der dazu bestimmt ist, bei einer vorbestimmten Betriebsfrequenz und in einem Temperaturbereich zu arbeiten, der sich um eine Bezugstemperatur $T_0$ zentriert, wobei der Resonator (10) umfasst:

- einen piezoelektrischen Wandler (12, 106; 406), der aus einer Schicht mit einer ersten Dicke eines ersten Material besteht, das nach einem ersten Wandler-Schnittwinkel $\varphi_1$, der durch die Nomenklatur (YXw)/$\varphi$ der Norm Std-176 (Revision 1949) definiert ist, von gleich im Wesentlichen Null geschnitten ist, und nach einem zweiten Wandler-Schnittwinkel $\theta_1$, der durch die Nomenklatur (YXl)/$\theta$ der Norm Std-176 (Revision 1949) definiert ist, geschnitten ist, und zwar so, dass der piezoelektrische Wandler (12; 106, 406) entweder eine erste Polarisierungsrichtung $\vec{P}_{Along}$ einer ersten Longitudinalschwingungsform des Wandlers (12; 106; 406) und eine zweite Polarisierungsrichtung $\vec{P}_{Acis\_dual}$ einer zweiten Scherschwingungsform des piezoelektrischen Wandlers (12; 106; 406) oder eine einzige Polarisierungsrichtung $\vec{P}_{Acis\_seul}$ aufweist, die einer Scherschwingungsform des Wandlers entspricht, und so, dass die elektroakustische Kopplung einer Scherschwingung und/oder einer Longitudinalschwingung für das Material des Wandlers höher als oder gleich 5% ist,
- ein akustisches Substrat (14; 110; 410), das aus einer Schicht mit einer zweiten Dicke eines zweiten Materials besteht, das ein Produkt aus einem Koeffizienten akustische Qualität - Erregungsfrequenz von mindestens gleich 5.10$^{12}$ hat, das nach einem ersten Substratschnittwinkel $\theta_2$, der durch die Nomenklatur (YXl)/$\theta$ der Norm Std-176 (Revision 1949) definiert ist, nach einem zweiten Substratschnittwinkel $\Psi_2$, der durch die Nomenklatur (YXt)/$\Psi$ der Norm Std-176 (Revision 1949) definiert ist, geschnitten ist, mindestens zwei Polarisierungsrichtungen aufweisend, darunter eine erste Polarisierungsrichtung $\vec{P}_{B1}$, eine zweite Polarisierungsrichtung $\vec{P}_{B2}$, eine dritte Polarisierungsrichtung $\vec{P}_{long}$, die einer Scherschwingungsform des Substrat (14; 110; 410) bei einer langsamen Phasengeschwindigkeit, einer Scherschwingungsform des Substrats bei einer schnellen Phasengeschwindigkeit bzw. einer Longitudinalschwingungsform des Substrats entsprechen,

- eine Gegenelektrode (19; 108; 408), die aus einer Metallschicht besteht, die eine erste Seite des piezoelektrischen Wandlers (12; 106; 406) und eine Seite des akustischen Substrats (14; 110; 410) verbindet, und
- eine obere Elektrode (18; 104; 404), die auf einer zweiten Seite des piezoelektrischen Wandlers (12; 106; 406) angeordnet ist, die zur ersten Seite des piezoelektrischen Wandlers (12; 106; 406) und dem Substrat (14; 110; 410) entgegengesetzt ist,

**dadurch gekennzeichnet, dass**
das Verhältnis der ersten Dicke zur zweiten Dicke kleiner als oder gleich 0,05 ist;
die Schnittwinkel $\varphi_1$, $\theta_1$, $\Psi_2$, $\theta_2$ und die relative Anordnung des piezoelektrischen Wandlers (12; 106; 406) und des Substrats (14; 110; 410) dergestalt ausgelegt sind,
dass gleichzeitig mindestens zwei Schwingungsformen des Substrats (14; 110, 410) bestehen, die stark im selben Grad an mindestens eine Schwingungsform des piezoelektrischen Wandlers (12; 106; 406) gekoppelt sind, und dass
die stark gekoppelten, mindestens zwei Schwingungsformen des Substrats (14; 110; 410) eine erste Schwingungsform mit einem ersten Temperaturkoeffizienten der Substratfrequenz der ersten Ordnung bei der Bezugstemperatur $T_0$ und eine zweite Schwingungsform des Substrats mit einem zweiten Temperaturkoeffizienten der Substratfrequenz der ersten Ordnung bei der Bezugstemperatur umfassen, und
der Wandler (14; 110; 410) für die erste Schwingungsform des Substrats einen ersten Temperaturkoeffizienten der Wandler-Frequenz der ersten Ordnung bei der Bezugstemperatur besitzt, und für die zweite Schwingungsform des Substrats einen zweiten Temperaturkoeffizienten der Wandler-Frequenz der ersten Ordnung bei der Bezugstemperatur besitzt, und
der Absolutwert der Differenz eines ersten und eines zweiten Temperaturkoeffizienten der Frequenz des Resonators (10) der ersten Ordnung größer als oder gleich 1 ppm/°K ist,
wobei der erste Temperaturkoeffizient der Frequenz des Resonators (10) der ersten Ordnung im Wesentlichen gleich der Summe des ersten Temperaturkoeffizienten der Frequenz des Substrats (14; 110; 410) der ersten Ordnung und des ersten Temperaturkoeffizienten der Frequenz des piezoelektrischen Wandlers (12; 106; 406) der ersten Ordnung gewichtet durch die relativen Dicken jedes Materials gegenüber der Gesamtdicke des Resonators ist, und
wobei der zweite Temperaturkoeffizient der Frequenz des Resonators (10) im Wesentlichen gleich der Summe des zweiten Temperaturkoeffizienten der Frequenz des Substrats (14; 110; 410) der ersten Ordnung und des zweiten Temperaturkoeffizienten der Frequenz des piezoelektrischen Wandlers (12; 106; 406) der ersten Ordnung gewichtet durch die relativen Dicken jedes Materials gegenüber der Gesamtdicke des Resonators ist.

2. Temperatursensor nach Anspruch 1, **dadurch gekennzeichnet, dass**
der piezoelektrische Wandler (106) nach einem Schnitt mit einfacher Drehung $(X_1Y_1l)/\theta_1$ geschnitten ist, und zwar so, dass der Wandler (106) eine erste Polarisierungsrichtung $\vec{P}_{Along}$ einer ersten Longitudinalschwingungsform des Wandlers und eine zweite Polarisierungsrichtung $\vec{P}_{Acis\_dual}$ einer zweiten Scherschwingungsform des Wandlers aufweist, und so, dass die elektroakustische Kopplung einer Welle in der Scherform und einer Welle in der Longitudinalform für dieses Material über 5% liegt, und
die Schnittwinkel $\theta_1$, $\Psi_2$, $\theta_2$, und die relative Anordnung des Wandlers (106) und des akustischen Substrats (110) dergestalt ausgelegt sind,
dass gleichzeitig drei Schwingungsformen des Substrats bestehen, die stark im selben Grad an eine von zwei Schwingungsformen des Wandlers gekoppelt sind, und dass
die stark gekoppelten drei Schwingungsformen des Substrats eine erste Schwingungsform des Substrats bei langsamer Scherung umfassen, die nach $\vec{P}_{B1}$ polarisiert ist und einen ersten Temperaturkoeffizienten der Substratfrequenz der ersten Ordnung bei der Bezugstemperatur hat, eine zweite Schwingungsform des Substrats bei schneller Scherung, die nach $\vec{P}_{B2}$ polarisiert ist und einen zweiten Temperaturkoeffizienten der Substratfrequenz der ersten Ordnung bei der Bezugstemperatur hat, und eine dritte Longitudinalschwingungsform, die nach $\vec{P}_{long}$ polarisiert ist und einen ersten Temperaturkoeffizienten der Substratfrequenz der ersten Ordnung bei der Bezugstemperatur hat,
wobei der Wandler (106) für die erste, zweite und dritte Schwingungsform des Substrats einen ersten, einen zweiten bzw. einen dritten Temperaturkoeffizienten der Wandler-Frequenz der ersten Ordnung bei der Bezugstemperatur besitzt,
wobei der Absolutwert der Differenz zweier beliebiger Temperaturkoeffizienten der Frequenz des Resonators (10) der ersten Ordnung einer Menge, die durch einen ersten, einen zweiten und einen dritten Temperaturkoeffizienten der Frequenz des Resonators der ersten Ordnung gebildet ist, höher als oder gleich 1 ppm/°K ist, wobei der erste Temperaturkoeffizient der Frequenz des Resonators (10) der ersten Ordnung im Wesentlichen gleich der Summe des ersten Temperaturkoeffizienten der Frequenz des Substrats der ersten Ordnung und des ersten Temperaturkoeffizienten der Frequenz des Wandlers der ersten Ordnung gewichtet durch die relativen Dicken jedes Materials gegenüber der Gesamtdicke des Resonators ist, und

wobei der zweite Temperaturkoeffizient der Frequenz des Resonators (10) im Wesentlichen gleich der Summe des zweiten Temperaturkoeffizienten der Frequenz des Substrats der ersten Ordnung und des zweiten Temperaturkoeffizienten der Frequenz des Wandlers der ersten Ordnung gewichtet durch die relativen Dicken jedes Materials gegenüber der Gesamtdicke des Resonators ist, und

wobei der dritte Temperaturkoeffizient der Frequenz des Resonators im Wesentlichen gleich der Summe des dritten Temperaturkoeffizienten der Frequenz des Substrats der ersten Ordnung und des dritten Temperaturkoeffizienten der Frequenz des Wandlers der ersten Ordnung gewichtet durch die relativen Dicken jedes Materials gegenüber der Gesamtdicke des Resonators ist.

3.  Temperatursensor nach Anspruch 1, **dadurch gekennzeichnet, dass**
der piezoelektrische Wandler (106) nach einem Schnitt mit einfacher Drehung $(X_1Y_1l)/\theta_1$ geschnitten ist, und zwar so, dass der Wandler (106) eine erste Polarisierungsrichtung $\vec{P}_{Along}$ einer ersten Longitudinalschwingungsform des Wandlers und eine zweite Polarisierungsrichtung $\vec{P}_{Acis\_dual}$ einer zweiten Scherschwingungsform des Wandlers aufweist, und so, dass die elektroakustische Kopplung einer Welle in der Scherform und einer Welle in der Longitudinalform für dieses Material über 5% liegt, und

die Schnittwinkel $\varphi_1$, $\theta_1$, $\Psi_2$, $\theta_2$ und die relative Anordnung des Wandlers (106) und des akustischen Substrats (110) dergestalt ausgelegt sind,

dass gleichzeitig nur zwei Schwingungsformen des Substrats bestehen, die stark im selben Grad an eine von zwei Schwingungsformen des Wandlers (106) gekoppelt sind, und dass

die stark gekoppelten zwei Schwingungsformen eine erste Scherschwingungsform des Substrats mit einem ersten Temperaturkoeffizienten der Substratfrequenz der ersten Ordnung bei der Bezugstemperatur eine zweite Longitudinalschwingungsform mit einem zweiten Temperaturkoeffizienten der Substratfrequenz der ersten Ordnung bei der Bezugstemperatur umfassen,

wobei der Wandler (106) für die erste und zweite Schwingungsform einen ersten bzw. einen zweiten Temperaturkoeffizienten der Frequenz des Wandlers der ersten Ordnung bei der Bezugstemperatur besitzt,

wobei der Absolutwert der Differenz eines ersten und eines zweiten Temperaturkoeffizienten der Frequenz des Resonators der ersten Ordnung höher als oder gleich 1 ppm/°K ist,

wobei der erste Temperaturkoeffizient der Frequenz des Resonators der ersten Ordnung im Wesentlichen gleich der Summe des ersten Temperaturkoeffizienten der Frequenz des Substrats der ersten Ordnung und des ersten Temperaturkoeffizienten der Frequenz des Wandlers der ersten Ordnung gewichtet durch die relativen Dicken jedes Materials gegenüber der Gesamtdicke des Resonators ist, und

wobei der zweite Temperaturkoeffizient der Frequenz des Resonators im Wesentlichen gleich der Summe des zweiten Temperaturkoeffizienten der Frequenz des Substrats der ersten Ordnung und des zweiten Temperaturkoeffizienten der Frequenz des Wandlers der ersten Ordnung gewichtet durch die relativen Dicken jedes Materials gegenüber der Gesamtdicke des Resonators ist.

4.  Temperatursensor nach Anspruch 1, **dadurch gekennzeichnet, dass**
das Material des piezoelektrischen Wandlers (106) Lithiumniobat oder Lithiumtantalat ist, und der Wandler (106) nach einem Schnitt mit einfacher Drehung $(X_1Y_1l)/\theta_1$ geschnitten ist, wobei der Schnittwinkel $\theta_1$ ein Winkel ist, der zwischen 0° und 25° beträgt.

5.  Temperatursensor nach Anspruch 1, **dadurch gekennzeichnet, dass** der piezoelektrische Wandler (406) nach einem Schnitt mit einfacher Drehung $(X_1Y_1l)/\theta_1$ geschnitten ist, und zwar so, dass der Wandler (406) eine einzige Polarisierungsrichtung $\vec{P}_{Acis\_seul}$ aufweist, die einer Scherschwingungsform des Wandlers entspricht, und so, dass die elektroakustische Kopplung einer Scherschwingung und/oder einer Longitudinalschwingung für das Material des Wandlers (406) höher als oder gleich 5% ist,

die Schnittwinkel $\theta_1$, $\Psi_2$, $\theta_2$ und die relative Anordnung des Wandlers (406) und des Substrats (410) dergestalt ausgelegt sind,

dass gleichzeitig zwei Scherschwingungsformen mit unterschiedlichen Phasengeschwindigkeiten bestehen, die stark im selben Grad an die Querschwingungsform des Wandlers gekoppelt sind, und dass

die stark gekoppelten zwei Schwingungsformen des Substrats eine erste Schwingungsform des Substrats (410) mit langsamer Scherung mit einem ersten Temperaturkoeffizienten der Substratfrequenz der ersten Ordnung bei der Bezugstemperatur, eine zweite Schwingungsform mit schneller Scherung des Substrats mit einem zweiten Temperaturkoeffizienten der Substratfrequenz der ersten Ordnung bei der Bezugstemperatur umfassen,

wobei der Winkel, der zwischen der einzigen Scherpolarisierungsrichtung des Wandlers (406) und der Scherpolarisierungsrichtung mit langsamer Phasengeschwindigkeit des Substrats (410) gebildet ist, und der Winkel, der zwischen der einzigen Scherpolarisierungsrichtung des Wandlers (406) und der Scherpolarisierungsrichtung mit schneller Phasengeschwindigkeit des Substrats (410) gebildet ist, im Wesentlichen gleich sind und sich auf gleich 45 Grad bemessen;

wobei der Wandler (406) für die erste und zweite Schwingungsform einen ersten bzw. einen zweiten Temperaturkoeffizienten der Frequenz des Wandlers der ersten Ordnung bei der Bezugstemperatur besitzt,

wobei der Absolutwert der Differenz eines ersten und eines zweiten Temperaturkoeffizienten der Frequenz des Resonators der ersten Ordnung höher als oder gleich 1 ppm/°K ist,

wobei der erste Temperaturkoeffizient der Frequenz des Resonators der ersten Ordnung im Wesentlichen gleich der Summe des ersten Temperaturkoeffizienten der Frequenz des Substrats der ersten Ordnung und des ersten Temperaturkoeffizienten der Frequenz des Wandlers der ersten Ordnung gewichtet durch die relativen Dicken jedes Materials gegenüber der Gesamtdicke des Resonators ist, und

wobei der zweite Temperaturkoeffizient der Frequenz des Resonators im Wesentlichen gleich der Summe des zweiten Temperaturkoeffizienten der Frequenz des Substrats (410) der ersten Ordnung und des zweiten Temperaturkoeffizienten der Frequenz des Wandlers (406) der ersten Ordnung gewichtet durch die relativen Dicken jedes Materials gegenüber der Gesamtdicke des Resonators ist.

6. Temperatursensor nach Anspruch 5, **dadurch gekennzeichnet, dass** das Material des piezoelektrischen Wandlers (106) Lithiumniobat oder Lithiumtantalat ist, und der Wandler (106) nach einem Schnitt mit einfacher Drehung $(X_1Y_1l)/\theta_1$ geschnitten ist, wobei der Schnittwinkel $\theta_1$ ein Winkel ist, der zwischen 155° und 176° beträgt.

7. Temperatursensor nach einem der Ansprüche 1 bis 6, **dadurch gekennzeichnet, dass** ein erster Temperaturkoeffizient der Frequenz des akustischen Substrats (14; 110; 410) im Wesentlichen Null beträgt oder von zum zweiten Temperaturkoeffizienten des Substrats (14; 110; 410) entgegengesetztem Vorzeichen ist.

8. Temperatursensor nach einem der Ansprüche 1 bis 6, **dadurch gekennzeichnet, dass** der Schnitt des Substrats dergestalt ist, dass der Temperaturkoeffizient der Frequenz der ersten Ordnung, welcher der mindestens einen Scherform des Substrats entspricht, mit einer Umkehrung seines Vorzeichens beidseits eines Winkels, der den Schnitt des Substrats definiert, im Wesentlichen Null beträgt.

9. Temperatursensor nach einem der Ansprüche 1 bis 6, **dadurch gekennzeichnet, dass** der Temperaturkoeffizient der Frequenz der ersten Ordnung des Substrats, welcher der mindestens einer der Scherformen des Substrats entspricht, ein lokaler Extremwert im Absolutwert von unter 20 ppm.$K^{-1}$ ist, und die Veränderung des Temperaturkoeffizienten in der Nähe dieses Extremwerts eine sanfte Veränderung ist, die im Absolutwert unter 2 ppm.$K^{-1}$/Grad beträgt.

10. Temperatursensor nach einem der Ansprüche 1 bis 9, wobei das Material des piezoelektrischen Wandlers (12; 106; 406) aus Aluminiumnitrid (AIN), Zinkoxid (ZnO), Lithiumniobat ($LiNbO_3$), Lithiumtantalat ($LiTaO_3$), Kaliumniobat, PZT, $PbTiO_3$ und piezoelektrischen Keramiken mit starker elektromechanischer Kopplung ausgewählt ist, und wobei das Material des akustischen Substrats (14; 110; 410) aus Quarz, Kaliumniobat, Lithiumtantalat, Galliumorthophosphat, Lithiumtetraborat, Langasit, Langatat und Langanit ausgewählt ist.

11. Temperatursensor nach einem der Ansprüche 1 bis 10, wobei die Gegenelektrode (19; 108; 408) ein thermokompressibles Metall, beispielsweise Gold, Kupfer oder Indium ist, und die obere Elektrode beispielsweise aus Aluminium hergestellt ist.

12. Temperatursensor nach einem der Ansprüche 1 bis 11, **dadurch gekennzeichnet, dass** der piezoelektrische Wandler (12; 106; 406) aus Lithiumniobat hergestellt ist; und das Material des akustischen Substrats (14; 110; 410) Quarz ist und das akustische Substrat nach einem Schnitt mit einfacher Drehung geschnitten ist, wobei der Schnittwinkel $\varphi_2$ Null beträgt, und $\theta_2$ ein Winkel zwischen -60 und 45 Grad ist.

**13.** Temperatursensor nach Anspruch 12, wobei der Schnittwinkel $\theta_1$ des Schnitts $(Y_1X_1l)/\theta_1$ des Lithiumniobats aus einer Zwischenweite zwischen 160 und 170°, vorzugsweise 163° ausgewählt ist, und der Schnittwinkel $\theta_2$ des Schnitts $(Y_2X_2l)/\theta_2$ des akustischen Substrats zwischen -48 und 35 Grad ausgewählt ist.

**14.** Temperatursensor nach Anspruch 12, wobei der Schnittwinkel $\theta_2$ des Schnitts $(Y_2X_2l)/\theta_2$ des akustischen Substrats (110; 410) zwischen -10 und 10° ausgewählt ist.

**15.** Temperatursensor nach einem der Ansprüche 1 bis 14, umfassend eine Einheit (20) zur Bestimmung der Differenz zwischen einer ersten Resonanzfrequenz und einer zweiten Resonanzfrequenz des Resonators HBAR bei einer im Inneren des Resonators herrschenden Temperatur T, die zwischen den zwei Elektroden desselben Paars des Resonators gemessen werden, und
eine Bestimmungseinheit (30) für die Temperatur T des Resonators ausgehend von der bestimmten Differenz der Frequenzen und einer eineindeutigen Korrespondenzfunktion zwischen der Temperatur und der Differenz der Frequenzen.

**Claims**

**1.** Temperature sensor comprising a resonator (10) of the high overtone bulk acoustic resonator HBAR type intended to operate at a predetermined operating frequency and in a temperature range centered around a reference temperature $T_0$, the resonator (10) including:

- a piezoelectric transducer (12, 106; 406) formed by a layer of a first thickness of a first material, cut according to a first transducer cut angle $\varphi_1$ defined by the nomenclature (YXw)/$\varphi$ of the IEEE Std-176 standard (revised in 1949) substantially equal to zero, and according to a second transducer cut angle $\theta_1$ defined by the nomenclature (YXl)/$\theta$ of the IEEE Std-176 standard (revised in 1949) such that the piezoelectric transducer (12; 106; 406) has, either a first polarization direction $\vec{P}_{Along}$ of a first longitudinal vibration mode of the transducer (12; 106; 406), and a second polarization direction $\vec{P}_{Acis\_dual}$ of a second shear vibration mode of the piezoelectric transducer (12;106; 406), or a single polarization direction $\vec{P}_{Acis\_seul}$ corresponding to a shear vibration mode of the piezoelectric transducer, and such that the electro-acoustic coupling of a shear vibration and/or of a longitudinal vibration for the material of the piezoelectric transducer is greater than or equal to 5%,
- an acoustic substrate (14; 110; 410) formed by a layer of a second thickness of a second material having an acoustic quality coefficient/excitation frequency product at least equal to $5.10^{12}$, cut according to a first substrate cut angle $\theta_2$ defined by the nomenclature (YXl)/$\theta$ of the IEEE Std-176 standard (revised in 1949), cut according to a second substrate cut angle $\psi_2$ defined by the nomenclature (YXt)/$\psi$ of the IEEE Std-176 standard (revised in 1949), having at least two polarization directions from among a first polarization direction $\vec{P}_{B1}$, a second polarization direction $\vec{P}_{B2}$, a third polarization direction $\vec{P}_{long}$, respectively corresponding to a shear vibration mode of the substrate (14; 110; 410) with a slow phase velocity, to a shear vibration mode of the substrate with a fast phase velocity, and to a longitudinal vibration mode of the substrate,
- a counter-electrode (19; 108; 408) formed by a metal layer adhesively bonding a first face of the piezoelectric transducer (12; 106; 406) and a face of the acoustic substrate (14; 110; 410), and
- an upper electrode (18; 104; 404) positioned on a second face of the piezoelectric transducer (12; 106; 406) opposite to the first face of the piezoelectric transducer (12; 106; 406) and to the substrate (14; 110; 410),
**characterized in that**
the ratio of the first thickness over the second thickness is less than or equal to 0.05;
the cut angles $\varphi_1$, $\theta_1$, $\psi_2$, $\theta_2$, and the relative positioning of the piezoelectric transducer (12; 106; 406) and of the substrate (14; 110; 410) are configured so that
there simultaneously exists at least two vibration modes of the substrate (14; 110; 410), strongly coupled to a same extent with at least one vibration mode of the piezoelectric transducer (12; 106; 406), and that
said at least two strongly coupled vibration modes of the substrate (14; 110; 410) comprise a first vibration mode having a first temperature coefficient of the frequency of the substrate of the first order at the reference temperature $T_0$ and a second vibration mode of the substrate having a second temperature coefficient of the frequency of the substrate of the first order at the same reference temperature, and
the piezoelectric transducer (14; 110; 410), for the first vibration mode of the substrate, has a first temperature coefficient of the frequency of the transducer of the first order at the reference temperature, and has for the second vibration mode of the substrate, a second temperature coefficient of the frequency of the transducer of the first order at the reference temperature, and

the absolute value of the difference of the first and second temperature coefficients of the frequency of the resonator (10) of the first order is greater than or equal to 1 ppm/°K,

the first temperature coefficient of the frequency of the resonator (10) of the first order being substantially equal to the sum of the first temperature coefficient of the frequency of the substrate (14; 110; 410) of the first order and of the first temperature coefficient of the frequency of the piezoelectric transducer (12; 106; 406) of the first order weighted by the relative thicknesses of each material relatively to the total thickness of the resonator, and

the second temperature coefficient of the frequency of the resonator (10) being substantially equal to the sum of the second temperature coefficient of the frequency of the substrate (14; 110; 410) of the first order and of the second temperature coefficient of the frequency of the piezoelectric transducer (12; 106; 406) of the first order weighted by the relative thicknesses of each material relatively to the total thickness of the resonator.

2. Temperature sensor according to claim 1, **characterized in that**

the piezoelectric transducer (106) is cut according to a cut with a simple rotation $(X_1Y_1l)/\theta_1$ such that the transducer (106) has a first polarization direction $\vec{P}_{Along}$ of a first longitudinal vibration mode of the transducer and a second polarization direction $\vec{P}_{Acis\_dual}$ of a second shear vibration mode of the transducer, and such that the electro-acoustic coupling of a shear mode wave and a longitudinal mode wave for this material is greater than 5%, et

the cut angles $\theta_1$, $\psi_2$, $\theta_2$, and the relative positioning of the transducer (106) and of the acoustic substrate (110) are configured so that

there simultaneously exists three vibration modes of the substrate, strongly coupled to a same extent with one of the two vibration modes of the transducer, and that

the three strongly coupled vibration modes of the substrate comprise a first slow shear vibration mode of the substrate, polarized along $\vec{P}_{B1}$ and having a first temperature coefficient of the substrate frequency of the first order at the reference temperature, a second fast shear vibration mode, polarized along $\vec{P}_{B2}$ and having a second temperature coefficient of the substrate frequency of the first order at the reference temperature, and a third longitudinal vibration mode, polarized along $\vec{P}_{long}$ and having a first temperature coefficient of the substrate frequency of the first order at the reference temperature,

the transducer (106) for the first, second, third vibration modes of the substrate respectively has first, second, third temperature coefficients of the transducer frequency of the first order at the reference temperature,

the absolute value of the difference of any two temperature coefficients of the frequency of the resonator (10) of the first order of a set formed by first, second and third temperature coefficients of the frequency of the resonator of the first order, is greater than or equal to 1 ppm/°K,

the first temperature coefficient of the frequency of the resonator (10) of the first order is substantially equal to the sum of the first temperature coefficient of the frequency of the substrate of the first order and of the first temperature coefficient of the transducer frequency of the first order weighted by the relative thicknesses of each material relatively to the total thickness of the resonator, and

the second temperature coefficient of the frequency of the resonator (10) being substantially equal to the sum of the second temperature coefficient of the frequency of the substrate of the first order and of the second temperature coefficient of the transducer frequency of the first order weighted by the relative thicknesses of each material relatively to the total thickness of the resonator, and

the third temperature coefficient of the frequency of the resonator being substantially equal to the sum of the third temperature coefficient of the frequency of the substrate of the first order and of the third temperature coefficient of the transducer frequency of the first order weighted by the relative thicknesses of each material relatively to the total thickness of the resonator.

3. Temperature sensor according to claim 1, **characterized in that**

the piezoelectric transducer (106) is cut according to a cut with a simple rotation $(X_1Y_1l)/\theta_1$ such that the transducer (106) has a first polarization direction $\vec{P}_{Along}$ of a first longitudinal vibration mode of the transducer and a second polarization direction $\vec{P}_{Acis\_dual}$ of a second shear vibration mode of the transducer, and such that the electro-acoustic coupling of a shear mode wave and of a longitudinal mode wave for this material is greater than 5%, and

the cut angles $\varphi_1$, $\theta_1$, $\psi_2$, $\theta_2$, and the relative positioning of the transducer (106) and of the substrate (110) are configured so that

there simultaneously exists only two vibration modes of the substrate strongly coupled to a same extent with one of the two vibration modes of the transducer (106), and that

both strongly coupled vibration modes of the substrate comprise a first shear vibration mode of the substrate having a first temperature coefficient of the substrate frequency of the first order at the reference temperature, a second longitudinal vibration mode having a second temperature coefficient of the substrate frequency of the first order at the reference temperature

the transducer (106) for the first, second vibration modes respectively has first and second temperature coefficients of the transducer frequency of the first order at the reference temperature,

the absolute value of the difference of first and second temperature coefficients of the frequency of the resonator of the first order is greater than or equal to 1 ppm/°K,

the first temperature coefficient of the frequency of the resonator of the first order being substantially equal to the sum of the first temperature coefficient of the frequency of the substrate of the first order and of the first temperature coefficient of the transducer frequency of the first order weighted by the relative thicknesses of each material relatively to the total thickness of the resonator, and

the second temperature coefficient of the frequency of the resonator being substantially equal to the sum of the second temperature coefficient of the frequency of the substrate of the first order and of the second temperature coefficient of the transducer frequency of the first order weighted by the relative thicknesses of each material relatively to the total thickness of the resonator.

4. Temperaturesensor according to claim 1, **characterized in that**
the material of the piezoelectric transducer (106) is lithium niobate or lithium tantalate and the transducer (106) is cut according to a cut with simple rotation $(Y_1X_1l)/\theta_1$ in which the cut angle $\theta_1$ is an angle comprised between 0° and 25°.

5. Temperaturesensor according to claim 1, **characterized in that**
the piezoelectric transducer (406) is cut according to a cut with simple rotation $(X_1Y_1l)/\theta_1$ such that the transducer (406) has a single polarization direction $\vec{P}_{Acis\_seul}$ corresponding to the shear vibration mode of the transducer, and such that the electro-acoustic coupling of a shear vibration and/or of a longitudinal vibration for the material of the transducer (406) is greater than or equal to 5%,

the cut angles $\theta_1$, $\psi_2$, $\theta_2$, and the relative positioning of the transducer (406) and of the substrate (410) are configured so that

there simultaneously exists two shear vibration modes with different phase velocities, strongly coupled to a same extent with the transverse vibration mode of the transducer, and that

both strongly coupled vibration modes of the substrate comprise a first slow shear vibration mode of the substrate (410) having a first temperature coefficient of the substrate frequency of the first order at the reference temperature, a second fast shear vibration mode of the substrate having a second temperature coefficient of the substrate frequency of the first order at the reference temperature

the angle formed between the single slow phase velocity shear polarization direction of the transducer (406) and the fast phase velocity shear polarization direction of the substrate (410), and the angle formed between the single shear polarization of the transducer (406) and the fast phase velocity shear polarization direction of the substrate (410) are substantially equal and with a measurement equal to 45°;

the transducer (406) for the first, second vibration modes respectively has first, second temperature coefficients of the transducer frequency of the first order at the reference temperature,

the absolute value of the difference of first and second temperature coefficients of the frequency of the resonator of the first order is greater than or equal to 1 ppm/°K,

the first temperature coefficient of the frequency of the resonator of the first order being substantially equal to the sum of the first temperature coefficient of the frequency of the substrate of the first order and of the first temperature coefficient of the transducer frequency of the first order weighted by the relative thicknesses of each material relatively to the total thickness of the resonator, and

the second temperature coefficient of the frequency of the resonator being substantially equal to the sum of the second temperature coefficient of the frequency of the substrate (410) of the first order and of the second temperature coefficient of the frequency of the transducer (406) of the first order weighted by the relative thicknesses of each material relatively to the total thickness of the resonator.

6. Temperaturesensor according to claim 5, **characterized in that**
the material of the piezoelectric transducer (406) is lithium niobate or lithium tantalate and the transducer (406) is cut according to a cut with simple rotation $(Y_1X_1l)/\theta_1$ in which the cut angle $\theta_1$ is an angle comprised between 155 and 176°.

7. Temperaturesensor according to any of claims 1 to 6, **characterized in that** a first temperature coefficient of the frequency of the acoustic substrate (14; 110; 410) is substantially zero or of sign opposite to the second temperature coefficient of the frequency of the substrate (14; 110; 410).

8. Temperaturesensor according to any of claims 1 to 6, **characterized in that** the cut of the substrate is such that the temperature coefficient of the frequency of the first order corresponding to said at least one shear mode of the substrate is substantially zero with inversion of its sign on either side of an angle defining the cut of the substrate.

9. Temperaturesensor according to any of claims 1 to 6, **characterized in that** the temperature coefficient of the frequency of the first order of the substrate corresponding to at least one of the shear modes of the substrate is a local extreme in absolute value of less than 20 ppm.$K^{-1}$ and the variation of the temperature coefficient in the vicinity of this extreme is a smooth variation in absolute value of less than 2 ppm.$K^{-1}$/degree.

10. Temperaturesensor according to any of claims 1 to 9, wherein
    the material of the piezoelectric transducer (12; 106; 406) is selected from aluminium nitride (AIN), zinc oxide (ZnO), lithium niobate ($LiNbO_3$), lithium tantalate ($LiTaO_3$), potassium niobate, PZT, $PbTiO_3$ and piezoelectric ceramics with strong electromechanical coupling, and
    wherein the material of the acoustic substrate (14; 110; 410) is selected from quartz, potassium niobate, lithium tantalite, gallium orthophosphate, lithium tetraborate, langasite, langatate and langanite.

11. Temperaturesensor according to any of claims 1 to 10, wherein the counter-electrode (19; 108; 408) is a heat-compressible metal, for example gold, copper or indium and the upper electrode is for example made in aluminium.

12. Temperaturesensor according to any of claims 1 to 11, **characterized in that**
    the piezoelectric transducer (12; 106; 406) is made in lithium niobate; and
    the material of the acoustic substrate (14; 110; 410) is quartz and the acoustic substrate is cut according to a cut with simple rotation wherein the cut angle $\varphi_2$ is zero, and $\theta_2$ is an angle comprised between -60 and 45 degrees.

13. Temperaturesensor according to claim 12, wherein the cut angle $\theta_1$ of the $(Y_1X_1l)/\theta_1$ cut of lithium niobate is selected from an interval comprised between 160 and 170°, preferably 163°, and the cut angle $\theta_2$ of the $(Y_2X_2l)/\theta_2$ cut of the acoustic substrate is selected from between -48 and 35 degrees.

14. Temperaturesensor according to claim 12, wherein the cut angle $\theta_2$ of the $(Y_2X_2l)/A_2$ cut of the acoustic substrate (110; 410) is selected from between -10 and 10°.

15. Temperature sensor according to any of claims 1 to 14, comprising a unit (20) for determining the difference between a first resonance frequency and a second resonance frequency of the HBAR resonator at a temperature T prevailing within the resonator, measured between both electrodes of the same pair of the resonator, and
    a unit (30) for determining the temperature T of the resonator from the determined frequency difference and from a one-to-one function of the match between the temperature and the frequency difference.

FIG.1

FIG.2

FIG.3

FIG.4

FIG.5

FIG.6

FIG.7

FIG.8

FIG.9

FIG.10

FIG.11

FIG.12

FIG.13

EP 2 665 999 B1

FIG.14

**FIG.15**

FIG.16

**FIG.17**

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2932333 A
- FR 2932334 A
- EP 1748556 A1

**Littérature non-brevet citée dans la description**

- **J.J. CAMPBELL ; W.R. JONES.** A method for estimating crystals cuts and propagation direction for excitation of piezoelectric surface waves. *IEEE Transactions on Sonics and Ultrasonics,* 1968, vol. 15, 209-217